# EUROPÄISCHE PATENTSCHRIFT

(11) **EP 1 518 275 B1**
(45) Veröffentlichungstag und Bekanntmachung des Hinweises auf die Patenterteilung: **06.05.2015**
(21) Anmeldenummer: 03735449.5
(22) Anmeldetag: 23.05.2003
(51) Int. Cl.: H01L 23/66, H01L 21/768

(54) **VERFAHREN ZUR HERSTELLUNG EINES BAUELEMENTS MIT HOCHFREQUENZTAUGLICHER LEITERANORNDNUNG UND ENTSPRECHENDES BAUELEMENT**
METHOD FOR PRODUCING A COMPONENT COMPRISING A CONDUCTOR STRUCTURE THAT IS SUITABLE FOR USE AT HIGH FREQUENCIES AND CORRESPONDING COMPONENT
PROCEDE DE PRODUCTION D'UN DISPOSITIF COMPRENANT UN ENSEMBLE DE CONDUCTEURS ADAPTES AUX HAUTES FREQUENCES ET DISPOSITIF CORRESPONDANT

(30) Priorität: 23.05.2002 DE 10222609; 15.04.2003 WO PCT/EP03/03907
(43) Veröffentlichungstag der Anmeldung: 30.03.2005
(73) Patentinhaber: Schott AG, 55122 Mainz (DE)
(72) Erfinder: LEIB, Jürgen, 85345 Freising (DE); MUND, Dietrich, 84101 Obersüssbach (DE)
(74) Vertreter: Herden, Andreas F.
(86) Internationale Anmeldenummer: PCT/EP2003/005415
(87) Internationale Veröffentlichungsnummer: WO 2003/100859

(56) Entgegenhaltungen:
- EP-A2- 1 168 609
- DE-A- 10 042 653
- DE-C1- 19 846 691
- US-A- 3 417 393
- US-A- 4 492 717
- US-A- 4 564 997
- US-A- 5 710 082
- US-A- 5 929 510
- 'Dünnschichttechnologie', [Online] DE.WIKIPEDIA.ORG, Gefunden im Internet: <URL:http://de.wikipedia.org/wiki/D%C3%BCnn schichttechnologie>
- SASSEN S ET AL: "Anodic bonding of evaporated glass structured with lift-off technology for hermetical sealing", SENSORS AND ACTUATORS A, ELSEVIER SEQUOIA S.A., LAUSANNE, CH LNKD- DOI:10.1016/S0924-4247(00)00300-9, vol. 83, no. 1-3, 1 May 2000 (2000-05-01), pages 150-155, XP004198307, ISSN: 0924-4247
- BHATTACHARYYA A. ET AL.: "Lift-Off Insulator Process", IBM TECHNICAL DISCLOSURE BULLETIN, vol. 21, no. 9, February 1979 (1979-02), pages 3577-3578, New York, US

## Beschreibung

### Beschreibung

Die Erfindung betrifft allgemein das Gebiet der Hochfrequenzschaltungen, insbesondere betrifft die Erfindung ein Verfahren zur Herstellung von hochfrequenztauglichen Leiterstrukturen auf einem Substrat.

Ein elektronischer integrierter Schaltkreis mit analogen und digitalen RF- und/oder Mikrowellenkomponenten ist aus der US 5,929,510 bekannt. Der integrierte Schaltkreis umfaßt ein Substrat aus elektrisch leitendem Material und einem Körper aus dielektrischem Material auf einer Seite des Substrats. Der dielektrische Körper ist aus einer Vielzahl von aufeinander gebondeten Lagen aus dielektrischem Material zusammengesetzt. Eine Vielzahl von Streifen aus leitendem Material befinden sich auf den dielektrischen Lagen des Körpers und bildet die analogen, digitalen und RF-Komponenten. Einzelne elektronische Komponenten sind auf dem Körper befestigt und an die Streifen aus leitendem Material angeschlossen. Um die Streifen aus leitendem Material auf den Lagen des Körpers zu verbinden, sind Vias aus leitendem Material durch die verschiedenen Lagen des Körpers vorgesehen.

Weiterhin offenbart die US 4,564,997 eine Halbleitervorrichtung, bei welcher eine Isolationsschicht in einer im Halbleitersubstrat geformten Rille abgeschieden ist, oder bei welcher eine Isolationsschicht darauf abgeschieden ist, um die Oberfläche des Substrats zu planarisieren. Außerdem ist aus der US 4,564,997 ein Herstellungsverfahren für eine Halbleitervorrichtung bekannt, bei welchem die Probe selektiv durch ein als Maske dienendes Resist-Muster weggeätzt, eine musterbildende Schicht mittels eines Plasma-Abscheideverfahrens abgeschieden und die Resist-Schicht entfernt wird, wobei die musterbildende Schicht eine geätzte Rille ausfüllt, um eine planarisierte Oberfläche zu erhalten.

Aus der DE 100 42 653 A1 ist außerdem eine keramische Mehrlagenschaltung aus zumindest zwei aufeinanderliegenden keramischen Schichten bekannt, bei welcher sich die beiden Schichten in ihrer Dielektrizitätskonstanten unterscheiden. Durch die unterschiedlichen Dielektrizitätskonstanten wird eine hochfrequenztaugliche keramische Mehrlagenschaltung realisiert. Auf den keramischen Schichten sind metallische Strukturen vorhanden, welche mittels Vias durch die Schichten miteinander verbunden sind. Zur Herstellung der keramischen Mehrlagenschaltung wird die an sich bekannte LTCC-Technologie (LTCC: "low temperature co-fired ceramics") vorgeschlagen.

Die US 4 492 717 A beschreibt ein Verfahren zur Herstellung einer planarisierten integrierten Schaltungsstruktur. Dazu wird die Schaltung mit einer Glasschicht beschichtet. Anschließend erfolgt zur Planarisierung ein Reflow, beziehungsweise ein Aufschmelzen der Glasschicht durch eine hinreichende Erhitzung. Ein Reflow zur Herstellung einer planarisierten Glasschicht auf einem Halbleiterwafer ist auch aus der EP 1 168 609 A2 bekannt.

Die US 5 710 082 A offenbart Borosilikat-Gläser mit niedriger Dielektrizitätskonstante für HochfrequenzSchaltungen.

Aus der US 3 417 393 A ist es bekannt, eine isolierende Glasschicht auf einem Halbleitersubstrat aufzubringen, indem eine Suspension mit Glaspartikeln aufgetragen wird. Die Glaspartikel sedimentieren dann zu einer Schicht, welche durch einen Reflow zu einer festen Glasschicht zusammengeschmolzen werden.

Die DE 198 46 691 C1 beschreibt ein Verfahren zur Mikrostrukturierung von Gläsern. Es wird ein Substrat bereitgestellt. Auf einer auf dem Substrat abgeschiedenen Glasschicht werden eine Aluminiumschicht und darauf eine Si02-Schicht aufgebracht.Mittels Photolithographie und Ätzen wird ein Bereich der SiO2-Schicht und der darunterliegenden Aluminiumschicht herausgearbeitet, wodurch das darunterliegende Substrat freigelegt wird. Es wird eine Glasschicht aufgedampft und dann die verbleibende Aluminiumschicht weggeätzt, wodurch die auf der Aluminiumschicht vorhandenen SiO2- und Glasschichten durch Lift-off entfernt werden.

Der Trend in der Halbleiterindustrie geht bekanntermaßen zu immer höheren Datenübertragungsraten. Bei Frequenzen im Gigaherz-Bereich kommt es dabei verstärkt zur Signaldämpfung an den Zu- und Ableitungssystemen. Für derartige Systeme werden bisher vor allem bedruckte keramische (HTCC) und glaskeramische (LTCC) Multilayerschichten eingesetzt, die nach Bedruckung mit leitfähigen Schichten, Laminierung und Sinterung eine dreidimensionale oder mehrschichtige Verdrahtung für eine Hochfrequenz-Schaltung realisieren. Außerdem kommen organische Multilayerschichten zum Einsatz, die nicht hermetisch sind.

Bei hohen Frequenzen nehmen jedoch bei derartigen Verdrahtungen die Übertragungsverluste durch die Dämpfung in den Leiterbahnen zu. Die Ursache für die hohe Dämpfung ist unter anderem in der Aufbringung der Leiterbahnen, üblicherweise mittels Dickfilmtechnik, insbesondere mittels Siebdruck begründet. Die mit dieser Technik hergestellten Leiterbahnen weisen eine große Imhogenität der Leiterbahnkonturen auf. Die Inhomogenitäten der Leiterbahnen wirken dabei wie Antennen, so daß es zu großen Abstrahlungsverlusten kommt.

Auch sind die Anwendungen für die verwendeten HTCC- und LTCC-Materialien hinsichtlich ihrer Hochfrequenzeigenschaften begrenzt, insbesondere der DK- und tanδ-Werte, so daß bisherige Hochfrequenzverdrahtungen mit HTCC- oder LTCC-Schichten nur bis zu Frequenzen von derzeit 40 GHz eingesetzt werden können. Die HTCC-und LTCC-Keramiken weisen eine unvermeidbare Körnung auf, welche die Hochfrequenzeigenschaften negativ beeinflussen und die dazu führt, daß die darin integrierten Leiterbahnen eine der Körnung entsprechende Oberflächenkontur haben, die ebenfalls zu Leitungsverlusten führt.

Ferner kommt es auch beim Sintern zwangsläufig zu einer Schrumpfung der Substrate, was ein genaues Einhalten von gewünschten Abmessungen erschwert.

Neuere Entwicklungen gehen dahin, die nachteilige Dickfilmtechnik durch Aufdampfen oder Aufsputtern der Leiterbahnen mittels verschiedener PVD-Verfahren zu ersetzen. Allerdings stellt das notwendige Sintern der HTCC- oder LTCC-Materialien für die Herstellung des Verdrahtungsstapels bei den bisherigen Verfahren immer noch ein großes Problem dar. So erfordert LTCC-Keramik zur Sinterung eine Temperatur von mindestens 950 °C. Für die Sinterung von HTCC-Keramiken ist sogar eine Temperatur von 1500 °C erforderlich. Bei diesen Temperaturen kommt es zu Veränderungen der Leiterbahnstrukturen und die Auswahl der Leiterbahn-Materialien ist eingeschränkt.

Der Erfindung liegt daher die Aufgabe zugrunde, Verfahren für bezüglich der Hochfrequenzeigenschaften verbesserte Leiterbahn-Systeme bereitzustellen. Diese Aufgabe wird bereits in höchst überraschend einfacher Weise durch ein Verfahren gemäß Anspruch 1 gelöst. Vorteilhafte Ausgestaltungen und Weiterbildungen sind Gegenstand der Unteransprüche.

Dementsprechend betrifft die Erfindung allgemein ein Verfahren zur Herstellung eines Bauelements mit hochfrequenztauglicher Leiteranordnung, bei welchem eine strukturierte Glasschicht mit zumindest einer Öffnung über einem Kontaktierungsbereich durch Aufdampfen auf einem Substrat abgeschieden und zumindest eine Leiterstruktur auf die Glasschicht aufgebracht wird, wobei die Leiterstruktur einen elektrischen Kontakt mit dem Kontaktierungsbereich aufweist.

Als hochfrequenztaugliche Leiterstrukturen werden dabei solche Leiterstrukturen verstanden, die Signale mit Frequenzen höher als 1GHz leiten und übertragen können.

Das Abscheiden der Glasschicht kann bevorzugt mit einer Vorrichtung, wie sie beispielsweise in dem deutschen Gebrauchsmuster mit der Anmeldenummer 202 05 830.1, beschrieben ist, insbesondere mit Elektronenstrahlverdampfung durchgeführt werden.

Gemäß der Erfindung erfolgt das Aufdampfen der Glasschicht durch Plasma-Ionen-unterstütztes Aufdampfen (PIAD). Dabei wird während des Aufdampfprozesse ein Ionenstrahl auf die zu beschichtende Oberfläche gerichtet. Dies führt zu einer weiteren Verdichtung und einer Verringerung der Defektdichte.

Bei dem erfindungsgemäßen Herstellen eines Bauelements mit einer Leiterstruktur, die gegenüber dem Substrat durch eine Isolationsschicht aus Aufdampfglas isoliert ist, wird gegenüber der Herstellung bisheriger LTCC- oder HTCC-Bauelemente auf ein Co-Firing bei hohen Temperaturen verzichtet. Dies ermöglicht so beispielsweise den Einsatz bisher nicht verwendbarer Materialien wie zum Beispiel Aluminium, die nicht bis zu den bei Co-Firing benötigten hohen Temperaturen stabil zu sein müssen.

Auf die Glasschicht können neben Leiterstrukturen, wie beispielsweise Leiterbahnen auch ein oder mehrere passive elektrische Bauelemente aufgebracht und mit der Leiterstruktur in Kontakt gebracht, beziehungsweise angeschlossen werden. Beispielsweise kann auf der Glasschicht als passives elektrisches Bauelement ein Kondensator, ein Widerstand, eine Spule, ein Varistor, ein PTC, ein NTC, oder ein Filterelement auf der Glasschicht aufgebracht werden.

Eine besonders vorteilhafte Ausführungsform der Erfindung sieht die Herstellung eines dreidimensionalen oder mehrlagigen Leitersystems auf einem Substrat vor. Dazu werden die Schritte des Abscheidens einer strukturierten Glasschicht und des Aufbringens zumindest einer Leiterstruktur mehrfach durchgeführt. Die einzelnen Glasschichten und/oder Leiterstrukturen können dabei unterschiedlich strukturiert sein, um ein dreidimensionales Leitersystem, insbesondere auch mit passiven Bauelementen, die auf einer oder mehreren Lagen des mehrlagigen Leitersystems ausgebildet werden, zu realisieren. Dabei kann vorteilhaft eine nachfolgend aufgebrachte Leiterstruktur mit einem Kontaktierungsbereich einer vorhergehend aufgebrachten Leiterstruktur verbunden werden, so daß zwischen zwei Lagen der Leiteranordnung ein elektrischer Anschluß geschaffen wird und die Lagen miteinander vernetzt werden können. Dementsprechend kann damit ein Bauelement ausgebildet werden, das eine mehrlagige Leiteranordnung mit zumindest zwei aufgedampften Glasschichten und jeweils darauf aufgebrachter Leiterstruktur aufweist, wobei eine Leiterstruktur auf einer ersten Glasschicht mit einer Leiterstruktur auf einer zweiten Glasschicht über eine Durchkontaktierung in elektrischem Kontakt sind.

Es ist jedoch auch möglich, zwei oder mehr übereinanderliegende oder versetzte Durchkontaktierungen in einzelnen aufeinanderliegenden Glasschichten in Kontakt zu bringen, so daß beispielsweise ein Kontaktierungsbereich des Substrats durch mehrere Glasschichten hindurch nach außen durchkontaktiert oder mit einer Leiterstruktur einer weiteren Lage verbunden wird.

Das erfindungsgemäße Verfahren beinhaltet, daß der Schritt des Erzeugens einer strukturierten Glasschicht mit zumindest einer Öffnung über einem Kontaktierungsbereich durch Aufdampfen die Schritte umfaßt:
- Aufbringen einer photolithographisch strukturierten Photolack-Zwischenschicht mit einer Struktur, welche den Kontaktierungsbereich abdeckt,
- Aufdampfen mittels PIAD einer Glasschicht auf das zwischen 50°C und 200°C gehaltene Substrat und die darauf befindliche strukturierte Zwischenschicht, wobei die Dicke der Glasschichten geringer ist als die der strukturierten Zwischenschicht, und
- Entfernen der strukturierten Zwischenschicht, wobei die Bereiche der Glasschicht, die sich auf der strukturierten Zwischenschicht befinden, zum Erzeugen der Öffnung mit abgehoben werden.

Die strukturierte Zwischenschicht wird somit durch photolithographische Strukturierung eines geeigneten Photolacks hergestellt. Auf diese Weise kann durch Aufdampfen und Abheben der Glasschicht im von der Zwischenschicht bedeckten Bereich eine genaue Strukturierung der Glasschicht mit gut definierten, glatten Kanten erreicht werden.

Eine Variante des Verfahrens sieht vor, vor dem Aufdampfen der Glasschicht auf den zumindest einen Kontaktierungsbereich ein leitendes, gegenüber zum Kontaktierungsbereich benachbarten Bereichen hervorragendes Material aufzubringen, welches von der Struktur der Zwischenschicht bedeckt wird. Damit wird eine leitende, erhabene Struktur auf dem Kontaktierungsbereich erzeugt. Dieser Schritt kann durchgeführt werden, indem etwa die Zwischenschicht zusammen mit einer Schicht aus leitfähigem Material photolithographisch strukturiert wird, wobei die Schicht aus leitfähigem Material zusammen mit der Zwischenschicht von den Bereichen, welche den Kontaktierungsbereich umgeben entfernt wird. Die Glasschicht kann dann vorteilhaft so aufgedampft werden, daß ihre Dicke im wesentlichen der Dicke des aufgebrachten, leitenden Materials entspricht, so daß nach dem Abheben der Glasschicht über dem Kontaktierungsbereich eine im wesentlichen ebene Oberfläche vorhanden ist.

Das Aufbringen einer Leiterstruktur kann außerdem vorteilhaft die Schritte des Aufbringens einer negativ strukturierten Zwischenschicht und des anschließenden Abscheidens von leitendem Material auf die mit der Zwischenschicht beschichtete Unterlage umfassen. Die Unterlage umfaßt dabei das Substrat und/oder das Substrat mit einer oder mehreren aufgebrachten Glasschichten und darauf angeordneten Leiterstrukturen. Diese Zwischenschicht kann photolithographisch strukturiert oder durch strukturiertes Bedrucken hergestellt sein.

Die Leiterstruktur ihrerseits kann vorteilhaft durch galvanisches Abscheiden, Aufsputtern oder Aufdampfen von elektrisch leitendem Material aufgebracht werden und dabei mit dem Kontaktierungsbereich der von der isolierenden Glasschicht abgedeckten Oberfläche der Unterlage in Kontakt gebracht werden.

Das Substrat selbst kann bereits eine Leiterstruktur, beispielsweise in Form von Leiterbahnen aufweisen. Diese können auch vorteilhaft vor dem Schritt des Abscheidens der strukturierten Glasschicht direkt auf das Substrat aufgebracht werden. Insbesondere kann dann auf einer direkt auf dem Substrat aufgebrachten Leiterbahn ein Kontaktierungsbereich vorgesehen werden, der dann mit einer nachfolgend auf einer isolierenden Glasschicht aufgebrachten Leiterstruktur in Kontakt gebracht wird. Auf diese Weise kann bereits nach einer einfachen Durchführung der Schritte des Abscheidens einer Glasschicht und des nachfolgenden Aufbringens zumindest einer Leiterstruktur auf die Glasschicht ein mehrlagiges, hochfrequenztaugliches Leiterbahnsystem, beziehungsweise eine mehrlagige hochfrequenztaugliche Leiteranordnung geschaffen werden. Selbstverständlich können dabei durch mehrfache Durchführung der Schritte des Abscheidens einer Glasschicht und Aufbringens einer Leiterstruktur noch weitere Lagen eines dreidimensionalen Leiterbahnsystems, insbesondere auch mit darin integrierten passiven Bauelementen geschaffen werden.

Beim Herstellen der Leiterstruktur können gemäß einer Weiterbildung des Verfahrens auch Strukturen mit unterschiedlichen leitenden und/oder halbleitenden Materialien aufgebracht werden. Die Materialien können dabei auch mit isolierenden Strukturen kombiniert werden. Durch derartige Kombinationen können weitere passive und aktive Bauelemente in einer oder mehreren Lagen auf der isolierenden Zwischenschicht erzeugt werden.

Ist die ein- oder mehrlagige Leiteranordnung auf dem Substrat fertiggestellt, kann zusätzlich eine weitere Glasschicht durch Aufdampfen abgeschieden werden, welche die vorherig aufgebrachten Schichten abdeckt. Um die Kontaktierung der Leiteranordnung auf dem Substrat zu ermöglichen, kann vorteilhaft zumindest eine Durchkontaktierung durch die Glasschicht geschaffen werden. Das Herstellen dieser Glasschicht kann dabei in gleicher Weise wie die Herstellung der darunterliegenden Glasschichten der Leiteranordnung erfolgen. Diese weitere Schicht kann als Isolationsschicht dienen, welche die Leiteranordnung nach außen hin isoliert. Zudem ist die Schicht aus aufgedampftem Glas auch sehr gut als Verkapselung für eine hermetische Verpackung des Bauelements geeignet.

Auf die Durchkontaktierung der äußeren Glasschicht kann außerdem noch eine Lötperle, vorzugsweise eine Anordnung von Lötperlen auf einer Vielzahl von Durchkontaktierungen aufgebracht werden, um das Bauelement nachfolgend beispielsweise auf einer SMT-Platine befestigen und anschließen zu können.

Eine Ausführungsform der Erfindung sieht außerdem vor, daß das Substrat ein Halbleitersubstrat mit einem aktiven Halbleiter-Bereich, bespielsweise in Form einer integrierten Halbleiterschaltung umfaßt. Dabei kann die zumindest eine Leiterstruktur beim Aufbringen mit einer Anschlußstelle des aktiven Halbleiter-Bereichs in Verbindung gebracht werden.

Bisher wurde beispielsweise bei LTCC-Modulen der Weg bestritten, einzelne Halbleiterbausteine monolithisch in Kavitäten in der Keramik zu integrieren, so daß die Keramik der Träger für die Halbleiterbausteine ist. Die Erfindung ermöglicht demgegenüber auch den umgekehrten Weg, wobei die Leiteranordnung direkt auf einem Chip aufgebracht wird und dieser so als Träger für die Leiteranordnung dient.

Gemäß einer Weiterbildung dieser Ausführungsform ist der aktive Halbleiter-Bereich auf einer ersten Seite des Substrats angeordnet, wobei das Erzeugen einer strukturierten Glasschicht mit zumindest einer Öffnung über einem Kontaktierungsbereich durch Aufdampfen auf das Substrat, und das Aufbringen der Leiterstruktur auf die Glasschicht auf der ersten Seite des Substrats erfolgt. Dabei bedeckt also die aufgebrachte Leiteranordnung mit der zumindest einen isolierenden Zwischenschicht mit aufgedampftem Glas die aktive Seite eines Halbleiter-Bausteins. Dies ermöglicht besonders kurze Leitungswege und reduziert so unter anderem die Abstrahlungsverluste.

Eine andere Weiterbildung der Erfindung sieht vor, die Glasschicht und die Leiterstruktur auf einer zweiten, der ersten Seite mit dem zumindest einen aktiven Halbleiter-Bereich gegenüberliegenden Seite aufzubringen. Um den aktiven Halbleiter-Bereich an die Leiteranordnung mit der Leiterstruktur anzuschließen, wird außerdem eine Durchkontaktierung durch das Substrat eingefügt, welche mit einer auf der ersten Seite angeordneten Anschlußstelle für den aktiven Halbleiter-Bereich verbunden ist. Die Durchkontaktierung ihrerseits wird auf der zweiten Seite dann beim Aufbringen der Leiterstruktur mit der Leiterstruktur verbunden. Diese Ausführungsform ist unter anderem dann vorteilhaft, wenn mehrere solcher Chips gestapelt werden sollen, so daß die Stapelung eine Umverlegung von Kontakten auf eine dem aktiven Halbleiter-Bereich gegenüberliegenden Seite erforderlich macht.

Selbstverständlich kann ein Substrat nicht nur auf einer Seite mit einer Leiteranordnung versehen werden. Gemäß noch einer vorteilhaften Weiterbildung der Erfindung führt das Verfahren vielmehr auf zwei gegenüberliegenden Seiten zu einer Leiteranordnung. Die Leiteranordnung umfaßt dabei,wie bei den anderen Ausführungsformen eine Glasschicht aus aufgedampftem Glas, wobei die Glasschicht zumindest eine Öffnung mit einer Durchkontaktierung aufweist, die in elektrischem Kontakt mit einem unter der Glasschicht liegenden Kontaktierungsbereich steht, sowie zumindest eine Leiterstruktur auf der Glasschicht, welche mit der Durchkontaktierung in Kontakt ist.

Erfindungsgemäß wird das Substrat während dem Aufdampfen der Glasschicht auf einer Temperatur zwischen 50 °C und 200 °C, bevorzugt zwischen 80 °C und 120 °C gehalten. Durch das Erwärmen des Substrates wird unter anderem das Entstehen von mechanischen Spannungen vermieden. Auch ist das mäßige Erwärmen vorteilhaft für die Morphologie der Glasschichten, wobei bei diesen Substrattemperaturen besonders porenfreie Glasschichten erzeugt werden konnten.

Positiv für die geforderte Schichtqualität ist auch ein Basisdruck in der Aufdampfkammer, der beim Aufdampfen der Glasschicht höchstens im Bereich von 10⁻⁴ mbar, bevorzugt im Bereich von 10⁻⁵ mbar oder geringer gehalten wird.

Um geschlossene Glasschichten mit geringer Porendichte auf dem Substrat herzustellen, ist es außerdem günstig, wenn die zu beschichtende Oberfläche des Substrats eine Oberflächenrauhigkeit von kleiner als 50 µm aufweist.

Noch eine weitere vorteilhafte Weiterbildung des erfindungsgemäßen Verfahrens sieht vor, die Glasschicht mit einer Abscheiderate von zumindest 0,5 µm Schichtdicke pro Minute aufzudampfen. Diese hohe Abscheiderate kann ohne Nachteil für die Schichtqualität der Glasschichten ohne weiteres erreicht werden und erlaubt eine kurze Herstellungszeit. Andere Vakuum-Abscheideverfahren, wie etwa Kathodenzerstäubung erreichen demgegenüber nur Abscheideraten von wenigen Nanometer pro Minute. Je nach Anwendung kann die Schichtdicke einer Aufdampfglasschicht zwischen 0,05 µm und 1,5 mm, bevorzugt in einem Bereich von 0,1 µm und 0,1mm liegen.

Als Aufdampfgläser dienen erfindungsgemäß Gläser, welche ein zumindest binäres Stoffsystem umfassen. Glasschichten, welche durch Verdampfung derartiger Gläser abgeschieden wurden, weisen aufgrund ihrer Defektarmut besonders gute Verkapselungs- und Hochfrequenzeigenschaften auf.

Um das Verfahren weiter zu rationalisieren und den Produktionsprozeß zu beschleunigen, kann gemäß noch einer vorteilhaften und bevorzugten Weiterbildung das Substrat im Waferverbund beschichtet werden. Die einzelnen Bauelemente werden dann durch Abtrennen des Substrats vom Wafer erhalten.

Als Substratmaterialien sind unter anderem Silizium, Keramik, Glas, oder sogar Kunststoff geeignet. Auch können Verbundmaterialien, beispielsweise Glas-KunststoffLaminate, insbesondere auch mit integrierten Leiteranordnungen verwendet werden. Neben Silizium können auch beispielsweise andere Halbleitermaterialien, wie etwa Galliumarsenid verwendet werden. Silizium, Glas und Keramik als Substratmaterial sind auch besonders aufgrund ihrer zum aufgedampften Glas sehr ähnlichen Temperaturausdehungskoeffizienten geeignet.

In der am gleichen Tag wie die vorliegende Anmeldung eingereichten internationalen Patentanmeldung der Anmelderin WO 03/100846 mit dem Titel "Glasmaterial für Hochfrequenzanwendungen" werden Glasmaterialien beschrieben, die besonders auch für die hier beschriebenen Verfahren einsetzbar sind.

Im folgenden wird angenähert die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale verschiedener Ausführungsformen miteinander kombiniert werden können.

Es zeigen:
- Fig. 1: eine Schnittdarstellung eines Bauelements mit einer Leiteranordnung,
- Fig. 2: eine Schnittdarstellung mit zwei Leiteranordnungen auf gegenüberliegenden Seiten eines Substrats,
- Fig. 3A bis 3H: anhand von Querschnittansichten die Schritte einer Ausführungsform eines erfindungsnahen Verfahrens,
- Fig. 4A bis 4E: eine Variante der in den Fig. 3B bis 3E gezeigten Verfahrensschritte,
- Fig. 5: im
- bis 7: Waferverbund mit einer Leiteranordnung versehene Bauelemente,
- Fig. 8: einen schematischen Layeraufbau für HF Messstruktur,
- Fig. 9: einen Layeraufbau offener Coplanarleitüngen CPW 1 2,
- Fig. 10: einen Layeraufbau vergrabener Coplanarleitungen CPW 3,
- Fig. 11: eine Auflistung von Eigenschaften von vermessenen Proben, wobei die Messwerte in den nachfolgenden Fig. 12 bis.23 dargestellt sind,
- Fig. 12 bis 14: den Betrag der Streuparameter und deren Phasenverlauf der Probe G1ACPW2_2 (Glas 8329),
- Fig. 15 bis 17: den Betrag der Streuparameter und deren Phasenverlauf der Probe G1ACPW3_2 (Glas 8329),
- Fig. 18 bis 20: den Betrag der Streuparameter und deren Phasenverlauf der Probe G2ACPW2_6 (Glas G018-189), und
- Fig. 21 bis 23: den Betrag der Streuparameter und deren Phasenverlauf der Probe G2ACPW3_2 (Glas G018-189).

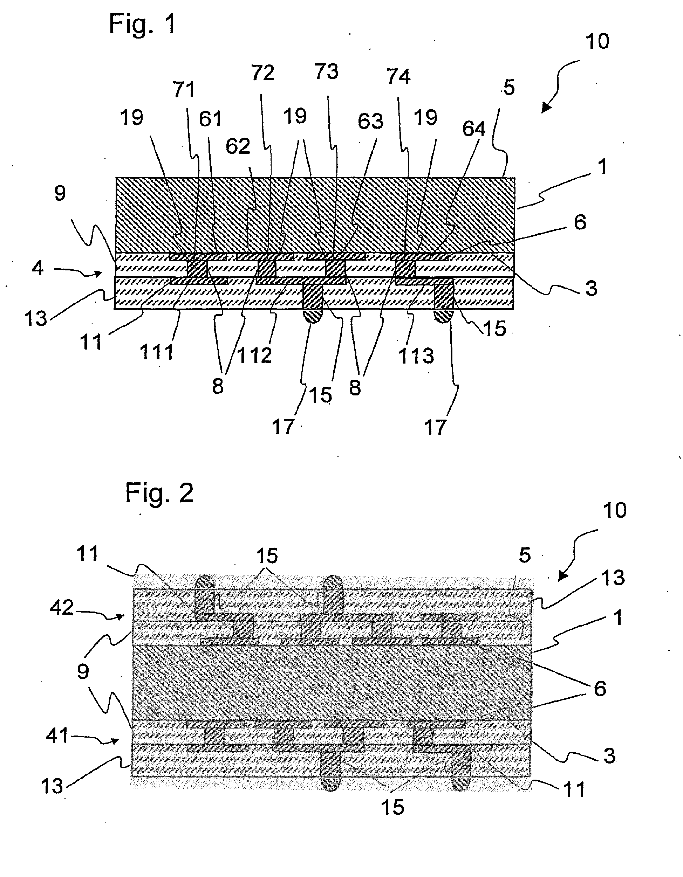

Fig. 1 zeigt eine vereinfachte Schnittdarstellung eines als Ganzes mit dem Bezugszeichen 10 bezeichneten Bauelements mit einem Substrat 1 mit einer ersten Seite 3 und einer der Seite 3 gegenüberliegenden Seite 5 und einer auf dem Substrat auf der ersten Seite 3 angeordneten, als Ganzes mit dem Bezugszeichen 4 bezeichneten Leiteranordnung. Auf dem Substrat ist eine Lage 6 mit Leiterstrukturen 61 - 64 angeordnet. Die Leiterstrukturen 61 - 64 können beispielsweise Leiterbahnen sein. Außerdem können einzelne der Leiterstrukturen 61 - 64 auch als passive elektrische Bauelemente ausgebildet sein. Auf diesen Leiterstrukturen 61 - 64 auf der ersten Seite 3 des Substrats 1 sind Kontaktierungsbereiche 71 - 74 definiert. Nachdem die Leiterstrukturen der Lage 6 aufgebracht sind, wird auf die erste Seite 3 des Substrats dann eine isolierende Glasschicht 9 durch Aufdampfen strukturiert abgeschieden, so daß sie Öffnungen 8 über den Kontaktierungsbereichen 71 - 74 aufweist. Diese Öffnungen 8 sind mit einem leitenden Material 19 gefüllt, so daß die Öffnungen in Verbindung mit den leitenden Füllungen jeweils Durchkontaktierungen durch die isolierende Glasschicht 9 schaffen. Auf der Glasschicht 9 ist eine Lage 11 mit weiteren Leiterstrukturen 111, 112, 113 aufgebracht. Die Leiterstrukturen 111, 112, 113 sind dabei jeweils mit zumindest einer der Durchkontaktierungen in Kontakt, so daß eine elektrische Verbindung der Leiterstrukturen 111, 112, 113 mit den Leiterstrukturen 61 - 64 der Lage 6 besteht. Damit weist das Substrat eine mehrlagige Leiteranordnung auf, deren Lagen 6 und 11 durch eine isolierende Glasschicht 9 mit hervorragenden Hochfrequenzeigenschaften voneinander getrennt sind.

Als besonders geeignet als Aufdampfglas für ein Bauelement 10 haben sich Gläser erwiesen, die folgende Zusammensetzungsbereiche in Gewichtsprozent aufweisen :

| Komponenten | Glasbereich1 | Glasbereich2 |
|---|---|---|
| SiO₂ | 75 - 85 | 65 - 75 |
| B₂O₃ | 10 - 15 | 20 - 30 |
| Na₂O | 1 - 5 | 0,1 - 1 |
| Li₂O | 0,1 - 1 | 0,1 - 1 |
| K₂O | 0,1 - 1 | 0,5 - 5 |
| Al₂O₃ | 1 - 5 | 0,5 - 5 |

Bevorzugte Aufdampfgläser aus diesen Gruppen sind Gläser der Firma Schott mit der folgenden Zusammensetzung in Gewichtsprozent:

| Komponenten | Glas1 | Glas2 |
|---|---|---|
| SiO₂ | 84,1 % | 71% |
| B₂O₃ | 11,0 % | 26 |
| %Na₂O | ≈2,0 % | 0,5% |
| Li₂O | ≈0,3 % | 0,5% |
| K₂O | ≈0,3 % | 1,0% |
| Al₂O₃ | 0,5 % | 1,0% |

Die bevorzugt verwendeten Gläser besitzen insbesondere die in der nachstehenden Tabelle aufgeführten Eigenschaften:

| Eigenschaften | Glas1 | Glas2 |
|---|---|---|
| α₂₀₋₃₀₀ [10⁻⁶K⁻¹] | 2,75 | 3,2 |
| Dichte (g/cm³) | 2,201 | 2,12 |
| Transformationspunkt [°C] | 562 °C | 466 °C |
| Brechungsindex | n_{D}=1, 469 | 1,465 |
| Wasserbeständigkeitklasse nach ISO 719 | 1 | 2 |
| Säurebeständigkeitsklasse nach DIN 12 116 | 1 | 2 |
| Laugenbeständigkeitsklasse nach DIN 52322 | 2 | 3 |
| Dielektrizitätskonstante s (25 °C) | 4,7 (1MHz) | 3,9 (40GHz) |
| tanδ (25 °C) | 45*10⁻⁴ (1MHz) | 26*10⁻⁴ (40GHz) |

Das Glas1 wird im folgenden auch als Glas 8329 und das Glas2 als G018-189 bezeichnet.

Auf der Lage 11 mit den Leiterstrukturen 111, 112, 113 ist eine weitere, abschließende Aufdampfglasschicht 13 abgeschieden, die als äußere Isolation der Leiterstrukturen 111, 112, 113 dient. Um eine Kontaktierung dieser Leiterstrukturen zu ermöglichen, sind außerdem weitere Durchkontaktierungen 15 in der abschließenden Aufdampfglasschicht 13 vorhanden, die mit den Leiterstrukturen 111, 112, 113 in Kontakt sind. Auf den Durchkontaktierungen 15 sind zusätzlich Lötperlen 17 aufgebracht, um das Bauelement 10 beispielsweise auf einer SMT-Platine zu befestigen und anzuschließen.

Fig. 2 zeigt eine Schnittdarstellung eines weiteren Bauelements 10. Dieses Bauelement weist auf zwei gegenüberliegenden Seiten 3 und 5 jeweils eine hochfrequenztaugliche Leiteranordnung 41, beziehungsweise 42 auf. Die Leiteranordnungen 41 und 42 sind dabei in analoger Weise wie die Leiteranordnung 4 des in Fig. 1 dargestellten Bauelements aufgebaut.

Im einzelnen weisen die Leiteranordnungen 41 und 42 dabei jeweils wieder eine Glasschicht 9 aus aufgedampftem Glas mit Öffnungen auf, in denen leitendes Material zur Durchkontaktierung vorhanden ist und in elektrischem Kontakt mit unter den Öffnungen angeordneten Kontaktierungsbereichen steht. Auf den Glasschichten 9 der Leiteranordnungen 41, beziehungsweise 42 sind jeweils Lagen 6 mit Leiterstrukturen angeordnet, die ihrerseits mit den Durchkontaktierungen in Kontakt sind. Ebenso wie bei dem in Fig. 1 gezeigten Bauelement sind die Leiterstrukturen auf der Glasschicht 9 mit weiteren, abschließenden Aufdampfglasschichten 13 abgedeckt, in denen Durchkontaktierungen 15 für den Anschluß des Bauelements vorhanden sind.

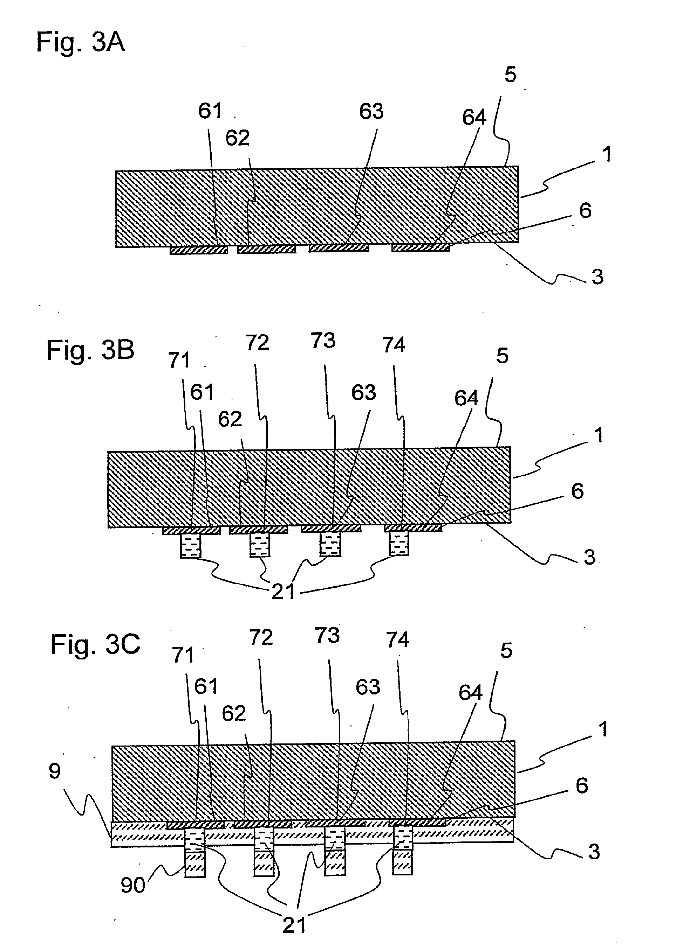

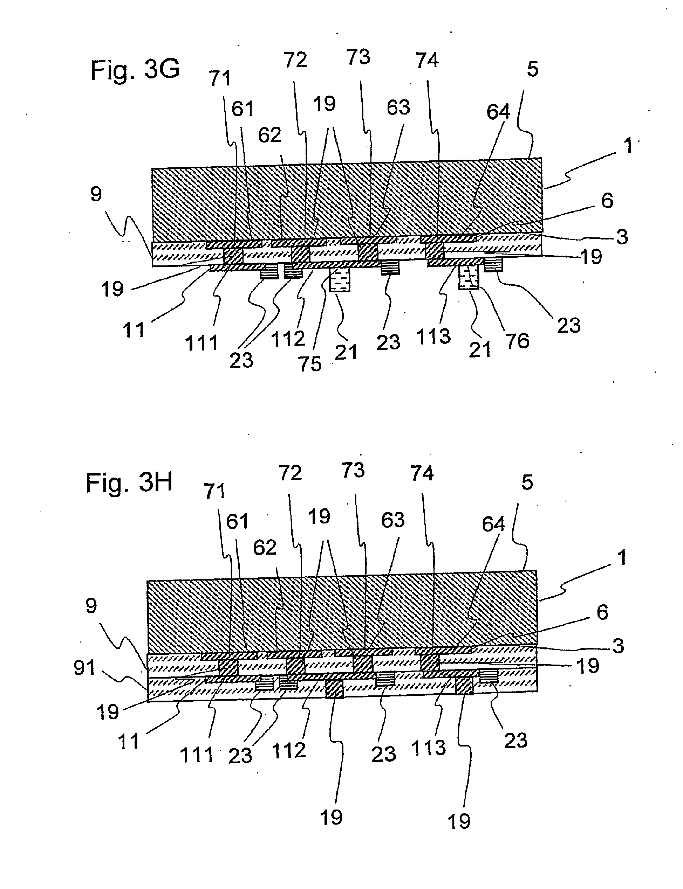

Die Fig. 3A bis 3H zeigen anhand von Querschnittansichten die Schritte zur Herstellung eines Bauelements gemäß einem erfindungsnahen Verfahren.

Die Fig. 3A zeigt ein Substrat 1 nach einem ersten Verarbeitungsschritt, bei welchem auf die Seite, auf welche die hochfrequenztaugliche Leiteranordnung aufgebracht wird, eine Lage 6 mit Leiterstrukturen 61 - 64, wie insbesondere von geeigneten Leiterbahnen hergestellt wird. Diese können beispielsweise Kontaktstellen von in Fig. 3A nicht dargestellten elektronischen Bauelementen des Substrats sein, oder an solche Kontaktstellen anschließen.

Nachfolgend wird in weiteren Verfahrensschritten eine Glasschicht abgeschieden, die Öffnungen über Kontaktierungsbereichen 71 -74 der darunter liegenden Oberfläche aufweist. Dazu wird zunächst, wie anhand von Fig. 3B dargestellt ist, in einem weiteren Schritt eine strukturierte Zwischenschicht mit Strukturen 21 aufgebracht, welche die jeweiligen Kontaktierungsbereiche 71 - 74 abdecken. Dies wird durch photolithographisches Strukturieren einer geeigneten Photolack-Beschichtung bewerkstelligt.

Anschließend wird, wie anhand von Fig. 3C dargestellt ist, eine Glasschicht 9 aufgedampft, welche sowohl die mit den Strukturen 21 der Zwischenschicht bedeckten Kontaktierungsbereiche 71 - 74, als auch die umgebenden Bereiche der Oberfläche der Unterlage bedeckt. Dabei ist die Dicke der Glasschicht 9 geringer als die Dicke der strukturierten Zwischenschicht. Die Zwischenschicht wird dann entfernt, wobei die Bereiche 90 der Glasschicht 9, welche die Strukturen 21 der Zwischenschicht bedecken, beziehungsweise welche sich auf der strukturierten Zwischenschicht befinden, mit abgehoben werden.

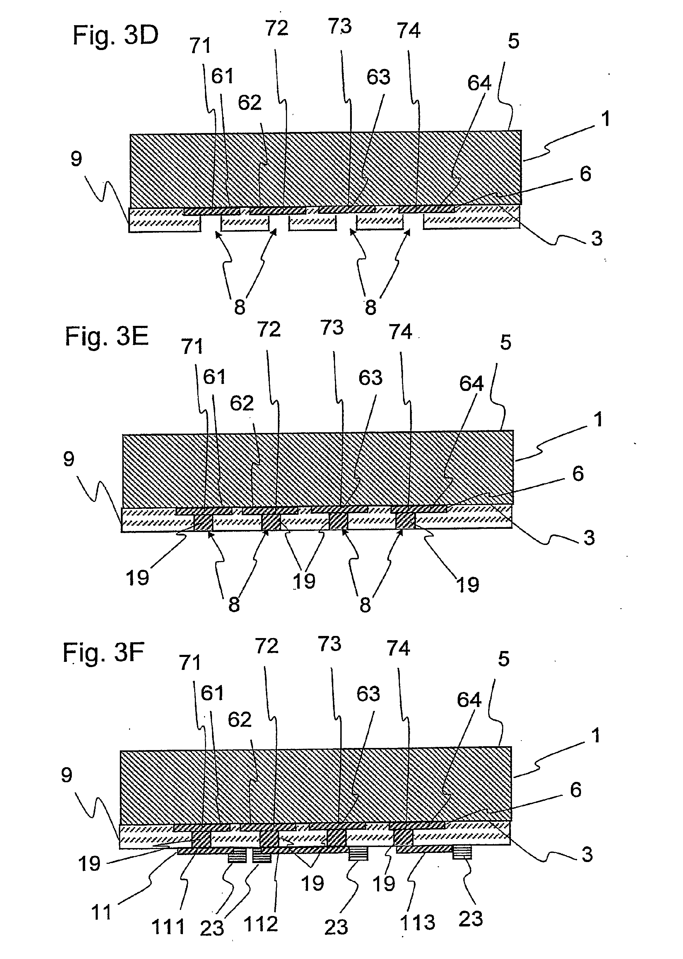

Fig. 3D zeigt das Substrat nach diesem Schritt, welches dementsprechend nun eine Glasschicht 9 mit Öffnungen 8 über den Kontaktierungsbereichen 71 - 74 der darunter liegenden Oberfläche aufweist. Die Öffnungen 8 können dann, wie in Fig. 3E gezeigt ist, beispielsweise mit einem leitenden Material 19 aufgefüllt werden. Auf der Glasschicht 9 kann dann eine Lage 11 mit Leiterstrukturen 111, 112, 113 und passiven Bauelementen 23 aufgebracht werden, wie Fig. 3F zeigt. Die Bauelemente 23 können beispielsweise ein Kondensator, ein Widerstand, eine Spule, ein Varistor, ein PTC, ein NTC, oder ein Filterelement umfassen. Kondensatoren und Spulen lassen sich insbesondere auch durch Leiterstrukturen übereinanderliegender, durch eine Aufdampfglasschicht zueinander isolierter Lagen realisieren. Beispielsweise kann dazu eine Leiterstruktur der Lage 6 und eine weitere, darüber liegende Leiterstruktur der Lage 11 verwendet werden.

Das Aufbringen der Leiterstrukturen kann beispielsweise durch Aufbringen einer weiteren, negativ strukturierten Zwischenschicht und das Abscheiden von elektrisch leitendem Material erfolgen, wobei die Leiterstrukturen 111, 112, 113 in Kontakt mit dem leitenden Material 19 in den Öffnungen 8 kommen, so daß auch eine elektrische Verbindung, beziehungsweise ein elektrischer Kontakt mit den jeweiligen zugeordnete Kontaktierungsbereichen 71 - 74 entsteht.

Die Leiterstrukturen können auch Strukturen mit unterschiedlichen leitenden Materialien oder auch Halbleitermaterialien aufweisen, beispielsweise indem das Aufbringen der Leiterstrukturen in mehreren Schritten unter Verwendung unterschiedlicher Materialien erfolgt. Damit können noch weitere Funktionalitäten in die Leiteranordnung integriert werden, beispielsweise, indem dadurch Halbleiter-Metall-Kontakte oder thermoelektrische Kontakte geschaffen werden.

Das in Fig. 3E gezeigte Herstellen der Durchkontaktierungen durch die Glasschicht 9 mit leitendem Material 19 und das in Fig. 3F dargestellte Aufbringen der Leiterstrukturen kann auch in einem Schritt erfolgen. Beispielsweise können die Leiterstrukturen 19 durch galvanisches Abscheiden hergestellt werden, so daß das abgeschiedene Material ausgehend von den Kontaktierungsbereichen 71 - 74 zunächst die Öffnungen 8 ausfüllt und dann weiter auf der Oberfläche der Glasschicht 9 aufwächst, wo es die Leiterstrukturen bildet, und auch, falls vorgesehen, die passiven Bauelemente 23 bilden kann. Ebenso können die Leiterstrukturen 111, 112, 113 auch durch Aufdampfen oder Aufsputtern hergestellt werden, wobei auch die Kontaktierungsbereiche 71 - 74 und Ränder der Öffnungen 8 mit bedampft oder beschichtet werden können, so daß die jeweiligen Leiterstrukturen in elektrischen Kontakt mit den Kontaktierungsbereichen 71 - 74 kommen.

Die Zwischenschicht kann anschließend wieder entfernt werden, wobei auf der Zwischenschicht abgeschiedenes leitendes Material abgehoben wird und die vorgesehenen Leiterstrukturen und eventuell aufgebrachten Bauelemente auch der Oberfläche der Glasschicht 9 zurückbleiben.

Die in den Fig. 3B bis 3F gezeigten Schritte des Erzeugens einer strukturierten Glasschicht mit Öffnungen über Kontaktierungsbereichen durch Aufdampfen auf das Substrat und des Aufbringens von Leiterstrukturen, die einen elektrischen Kontakt mit zugeordneten Kontaktierungsbereichen aufweisen, können dann zur Herstelllung weiterer Lagen der Leiteranordnung wiederholt werden; wobei eine nachfolgend aufgebrachten Leiterstruktur mit einem Kontaktierungsbereich einer vorhergehend aufgebrachten Leiterstruktur in Kontakt gebracht wird.

Dazu wird wieder, wie in Fig. 3F bis 3H gezeigt eine Zwischenschicht mit Strukturen 21 auf vorgesehene Kontaktierungsbereiche 75, 76 der Oberfläche des beschichteten Substrats 1 aufgebracht, wobei die Kontaktierungsbereiche sich zweckmäßigerweise auf aufgebrachten Leiterstrukturen, oder auch auf Durchkontaktierungen befinden. Anschließend wird eine weitere isolierende Glasschicht 91 mit Durchkontaktierungen durch Öffnungen in der Glasschicht 91 über den Kontaktierungsbereichen 75, 76 hergestellt, wobei die Herstellung analog zu den anhand der Fig. 3C bis 3E beschriebenen Verfahrensschritten erfolgt.

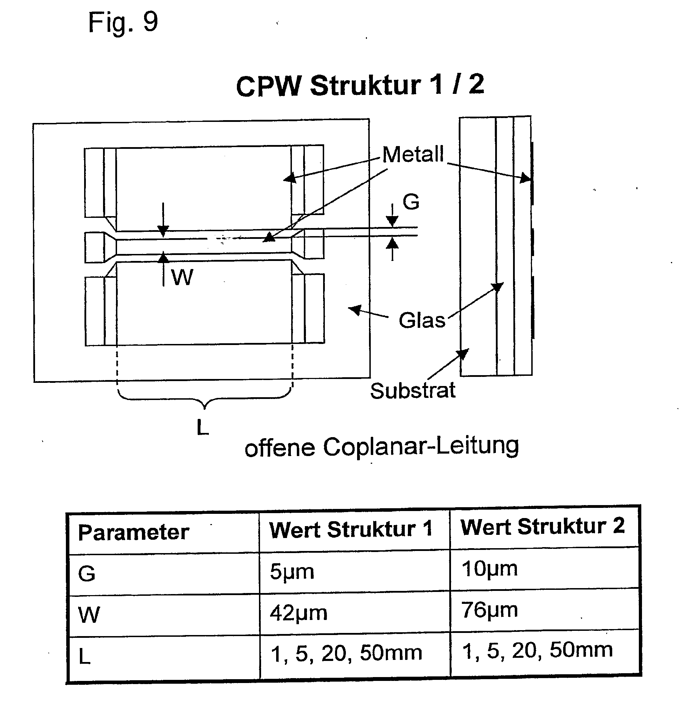

Die Fig. 9A bis 4E zeigen eine Variante der anhand der Fig. 3B bis 3E gezeigten Verfahrensschritte. Diese Variante basiert darauf, vor dem Aufdampfen der Glasschicht auf die Kontaktierungsbereiche ein leitendes, gegenüber zum jeweiligen Kontaktierungsbereich benachbarten Bereichen hervorragendes Material aufzubringen, welches von der Struktur der Zwischenschicht bedeckt wird. Dieses leitfähige Material bildet dann später die Durchkontaktierung.

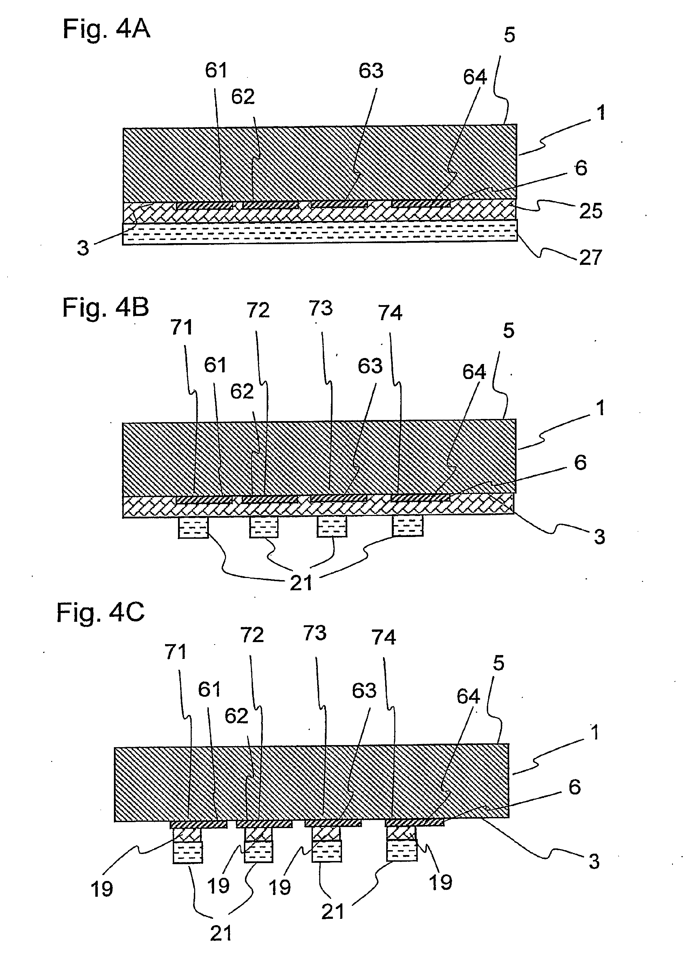

Im einzelnen wird zunächst, ausgehend von einem wie in Fig. 3A vorbereiteten Substrat 1 eine leitende Schicht 25 und darauf eine photostrukturierbare Zwischenschicht 27 aufgebracht, wie anhand von Fig. 4A dargestellt ist.

Fig. 4B zeigt das Substrat nach einer photolithographischen Strukturierung der Zwischenschicht 27..Die Schicht wird so strukturiert, daß Strukturen 21 stehen bleiben, welche die vorgesehenen Kontaktierungsbereiche 71 - 74 abdecken. Anschließend wird, wie Fig. 4C zeigt, die leitende Schicht 25 von den nicht bedeckten, die Kontaktierungsbereiche 71 - 74 umgebenden Bereichen entfernt. Dies kann in fachüblicher Weise beispielsweise durch Ätzen erfolgen. Dementsprechend werden die Kontaktierungsbereiche 71 - 74 von einem leitenden Material bedeckt, welches gegenüber zum jeweiligen Kontaktierungsbereich benachbarten Bereichen erhaben ist, beziehungsweise hervorragt und welches jeweils von einer Struktur 21 der Zwischenschicht 27 bedeckt wird.

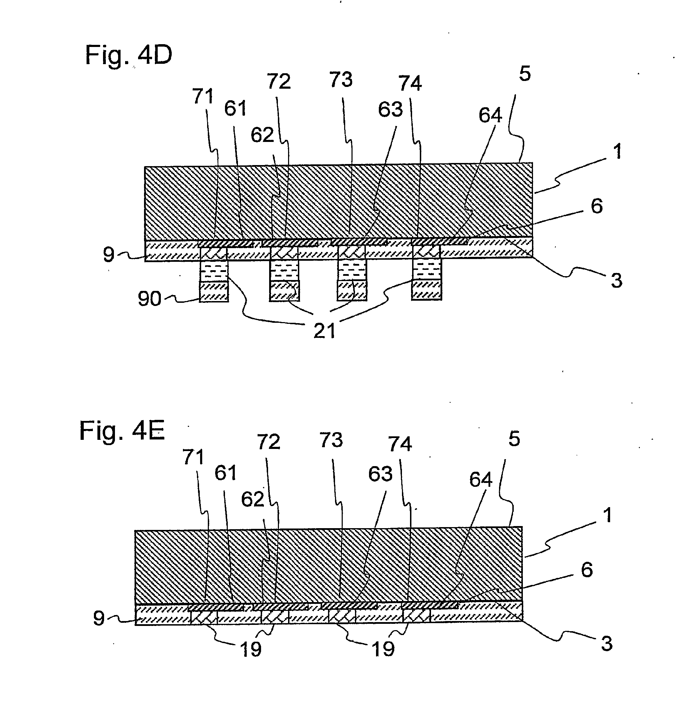

Anschließend wird, wie in Fig. 4D gezeigt, die isolierende Glasschicht 9 aufgedampft, wobei vorzugsweise die Dicke der Glasschicht 9 so gewählt wird, daß sie in etwa der Dicke des erhabenen leitenden Materials 19 entspricht. Schließlich werden die Strukturen 21 der Zwischenschicht, beispielsweise, durch Anwendung eines geeigneten Lösungsmittels entfernt und dabei die Bereiche 90 der Glasschicht 9, welche die Strukturen 21 bedecken, abgehoben. Auf diese Weise wird ein Substrat mit einer Glasschicht erhalten, die Öffungen über den jeweiligen Kontaktierungsbereichen und Durchkontaktierungen in Gestalt des in den Öffnungen befindlichen leitenden Materials aufweist. Dieser Verarbeitungszustand ist in Fig. 4E gezeigt. Durch die geeignete Wahl der an die Dicke des leitenden Materials 19 angepaßten Schichtdicke der Glasschicht 9 sind die Oberfläche des leitenden Materials 19 und der Glasschicht 9 in etwa auf gleicher Höhe, so daß eine ebene Oberfläche erhalten wird. Das Verfahren kann anschließend weiter wie anhand der Fig. 3F bis 3H erläutert ist, fortgesetzt werden, wobei auch die zweite Glasschicht 91 in Fig. 3H und eventuelle weitere Glasschichten mit Durchkontaktierungen in gleicher oder ähnlicher Weise hergestellt werden können, wie anhand der Fig. 4A bis 4E erläutert wurde.

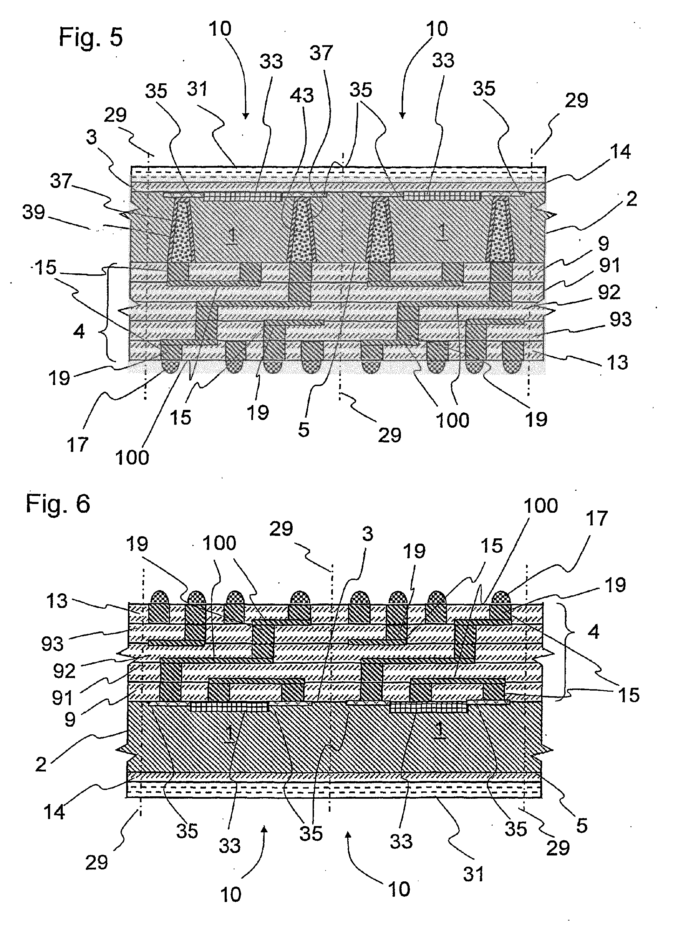

Gemäß einer vorteilhaften Weiterbildung des Verfahrens werden die Bauelemente 10 durch Beschichten von Substraten im Waferverbund hergestellt. Die Fig. 5 bis 7 zeigen dazu verschiedene Beispiele beschichteter Wafer 2, wobei die Bauelemente durch Abtrennen einzelner Substrate 1 vom Wafer erhalten werden.

Fig. 5 zeigt ein Beispiel, bei welcher ein Halbleiterwafer 2 mit einer Folge aus Glas- bzw. Leiterbahnenschichten versehen worden ist. Bevorzugt wird als Wafermaterial hierzu Silizium verwendet, da dieses Material einen sehr gut mit dem Aufdampfglas übereinstimmenden Temperaturausdehnungskoeffizienten aufweist. Die einzelnen Substrate 1 werden nach der Beschichtung im Waferverbund und dem Herstellen des in Fig. 5 gezeigten Verarbeitungszustandes durch Abtrennen entlang der vorgesehenen Trennnachsen 29 abgetrennt, um schließlich Bauelemente 10 mit hochfrequenzfähiger Leiterstruktur zu erhalten.

Der Wafer 2 weist auf einer ersten Seite 3 einzelne aktive Halbleiter-Bereiche 33 auf, die mit Anschlußstellen 35 verbunden sind.

Die Leiteranordnung 4 ist bei diesem Beispiel auf einer zweiten Seite 5 des Wafers 2, beziehungsweise der Substrate 1 des Wafers 2 angeordnet, welche der ersten Seiten mit den aktiven Halbleiter-Bereichen 33 gegenüberliegt.

Die Leiteranordnung 4 ist zum Zwecke der Übersichtlichkeit vereinfacht dargestellt, wobei hier unter anderem alle Leiterstrukturen mit dem Bezugszeichen 100 bezeichnet sind. Die einzelnen Lagen der Leiteranordnung 4 können vorteilhaft wie anhand der Fig. 3A bis 3H und/oder der Fig. 4A bis 4E erläutert wurde, hergestellt werden. Insbesondere ist die in Fig. 5 gezeigte Leiteranordnung 4 auch mehrlagig gefertigt, wobei dazu entsprechend die Schritte des Abscheidens einer strukturierten Glasschicht und des Aufbringens von Leiterstrukturen 100 entsprechend mehrfach durchgeführt werden, und wobei eine nachfolgend aufgebrachte Leiterstruktur 100 mit einem Kontaktierungsbereich einer vorhergehend aufgebrachten Leiterstruktur 100 in Kontakt gebracht wird.

In den Wafer 2 sind außerdem Durchkontakte 37 durch die Substrate 1 eingefügt, welche mit den Anschlußstellen 35 elektrisch verbunden sind. Die Herstellung der Durchkontakte kann bevorzugt durch Ätzen von Ätzgruben in den Wafer von der zweiten Seite 5 her bis auf die vorzugsweise metallischen Anschlußstellen 35 erfolgen, die gleichzeitig als Ätzstop wirken. Anschließend wird eine Passivierungsschicht 39 auf den Wänden der Ätzgrube erzeugt und die Ätzgrube mit leitendem Material 43 aufgefüllt. Das auf der Seite 3 offenliegende leitende Material 43 der Durchkontakte 37 dient als Kontaktierungsbereich für Leiterstrukturen 100 der Leiteranordnung 4.

Die Bereiche der Oberfläche der zweiten Seite 5 mit den Durchkontakten werden außerdem als Kontaktierungsbereiche für einige der Leiterstrukturen 100 der Leiteranordnung 4 verwendet. Werden diese Leiterstrukturen 100 beim Aufbringen auf der zuvor abgeschiedenen Glasschicht 9 mit den Kontaktierungsbereichen in Kontakt gebracht, so werden die Leiterstrukturen dementsprechend dabei auch mit den Anschlußstellen 35 auf der ersten Seite der Substrate 1 elektrisch verbunden. Auf diese Weise können dann die aktive Halbleiter-Bereiche 33 über die Leiteranordnung versorgt und elektrische Signale von den aktiven Halbleiter-Bereichen auf die Leiterstrukturen 100 der Leiteranordnung 4 gegeben werden.

Zur Verkapselung und zum Schutz der später durch Abtrennen gewonnenen Bauelemente ist das in Fig. 5 gezeigte Biespiel auf der Seite 3 noch mit einer zusätzlichen Aufdampfglas-Verkapselungsschicht 14 und/oder einer Kunststoff-Abdeckung 31 versehen.

Fig. 6 zeigt ein weiteres Biespiel, wobei ebenfalls im Waferverbund verbundene Substrate mit einer Leiteranordnung 4 beschichtet wurden. Dieses Beispiel ist ähnlich zu dem in Fig. 5 gezeigten. Auch bei dem in Fig. 6 gezeigten Beispiel wird ein Halbleiter-Wafer 2 mit aktiven Halbleiter-Bereichen 33 verwendet, die einzelnen Substraten 1 zugeordnet sind. Ebenso wie bei dem in Fig. 5 gezeigten Beispiel werden beim Aufbringen der Leiterstrukturen 100 auf der ersten Glasschicht 9 der Leiteranordnung 4 die Anschlußstellen 35 der aktive Halbleiter-Bereiche 33 mit Leiterstrukturen 100 in Verbindung gebracht.

Im Unterschied zu Fig. 5 werden die Glasschichten 9, 91, 92, 93 und 13 der Leiteranordnung 4 jedoch auf der ersten Seite 3 der Substrate 1, auf welcher auch die aktiven Halbleiter-Bereiche 33 angeordnet sind, aufgedampft. Die Durchkontaktierungen 15 in der untersten Glasschicht 9 der Leiteranordnung 4 werden direkt auf den Kontaktstellen 35 aufgebracht, wobei die Kontaktstellen 35 dementsprechend die Kontaktierungsbereiche der Substrate 1 für die entsprechenden Leiterstrukturen 100 auf der ersten Glasschicht 9 bilden.

Die Bauelemente 10, die durch Abtrennen von den beschichteten Wafern 2 gewonnen werden, wie sie beispielhaft in den Fig. 5 und 6 dargestellt sind, können beispielsweise als Hochfrequenz- Sende-/Empfangsmodule für Frequenzen oberhalb von 10 GHz ausgebildet sein.

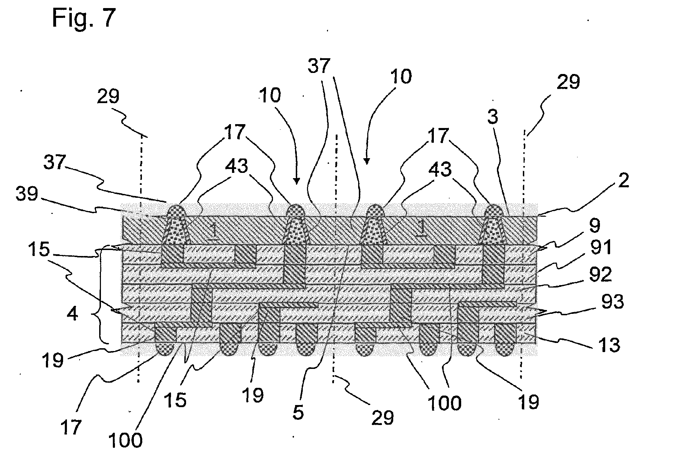

Fig. 7 zeigt noch ein weiteres Biespiel von Substraten 1, die im Waferverbund mit einer hochfrequenztauglichen Leiteranordnung 4 versehen wurden. Die Leiteranordnung 4 mit den Glasschichten 9, 91, 92, 93, 13 und den Leiterstrukturen 100 ist hier auf einem Wafer aufgebracht, dessen Substrate 1 ebenfalls Durchkontakte 37 aufweisen. Die Bauelemente 10 mit Substrate 1 und Leiteranordnungen 4 dienen nach dem Abtrennen vom Wafer als Hochfrequenz-Umverdrahtungssubstrat für weitere Bauelemente, die mit den außen liegenden Kontaktstellen der Bauelemente 10 verbunden werden können. Die außen liegenden Kontaktstellen sind dazu beispielhaft mit Lötperlen 17 versehen, so daß weitere Bauelemente in SMT-Technologie befestigt und angeschlossen werden können. Die Substrate 1 weisen hier keine aktiven Bauelemente auf. Dementsprechend kann der Substratwafer 2 auch aus isolierendem Material, wie beispielsweise Glas oder Kunststoff gefertigt werden. Ein besonders gut geeignetes Glas als Material für den Wafer, beziehungsweise die Substrate 1 der Bauelemente 10 ist Borofloat^{®}-Glas, welches einen nahezu mit dem bevorzugten Aufdampfglas übereinstimmenden Temperaturausdehnungskoeffizienten aufweist.

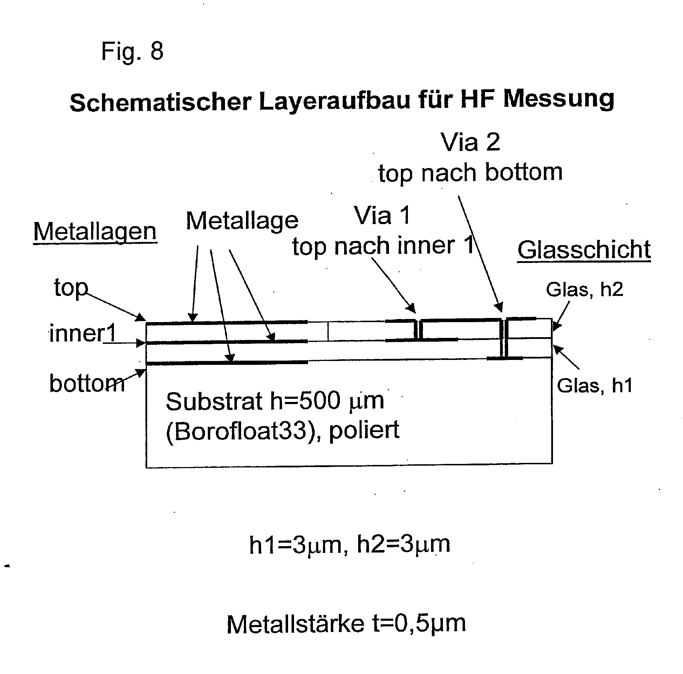

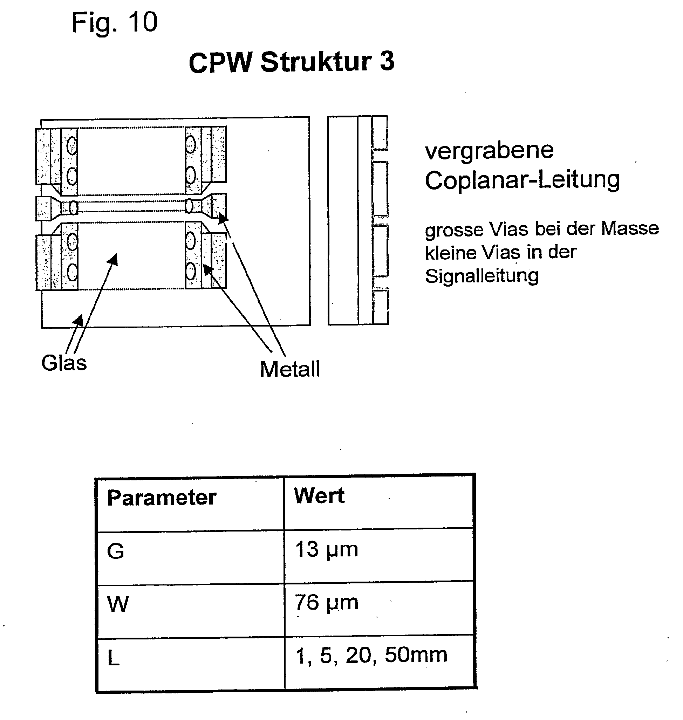

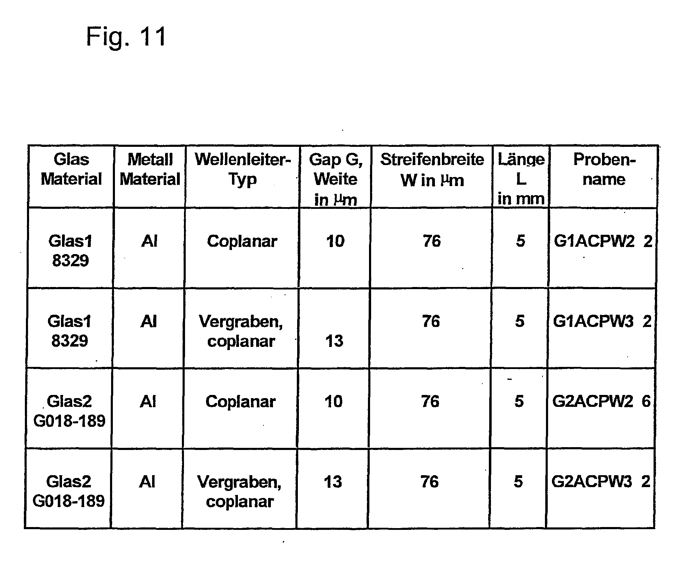

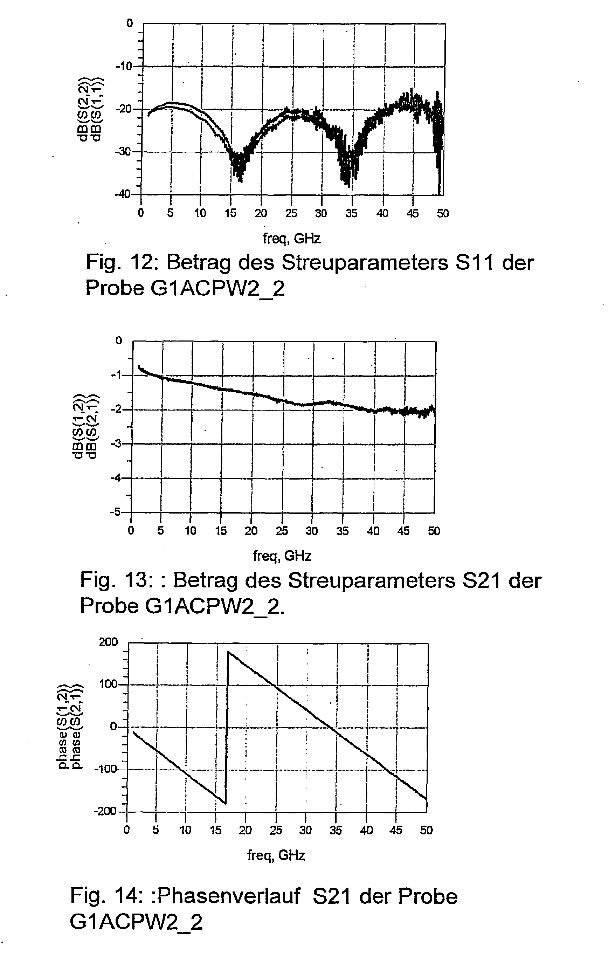

Fig. 8 zeigt den für die Charakterisierung der HF Eigenschaften schematischen Layeraufbau mit den Schichtdicken der vermessenen Teststrukturen. In den Fig. 9 und 10 sind realisierte Strukturen von offenen und vergrabenen Coplanarleitungen dargestellt. Nachfolgende Messungen der Streuparameter S12, S21, S11 und S22 konnten anhand dieser Strukturen realisiert werden. Die Probenbezeichnungen zu den ausgewählter Messungen, die in den Fig. 12 bis 23 gezeigt sind, sind aus der Tabelle in Fig.11 zu entnehmen.

Die Fig. 12 bis 14 zeigen den Betrag der Streuparameter S11 und S22 , S12 und S21 sowie den Phasenverlauf des Streuparameters S12 und S21 einer offenen Coplanarleitung unter Verwendung des Glases 8329 als Isolator zwischen den Aluminiumleiterbahnen. Die Streuparameter S12 und S21 werden auch als Durchgangsdämpfung und die Streuparameter S11 und S22 als Reflexionsdämpfung bezeichnet.

Deutlich zeigt sich in Fig. 12 eine extrem geringe Reflektion S11 und S22 der Signale an dieser Probe von -20dB bis -40dB bis zu einer Frequenz von 50GHz. Weiterhin sind geringe Dämpfungswerte von kleiner -2dB bei den Streuparametern S12 und S21 anhand der in Fig. 13 dargestellten Meßwerte bis zu einer Frequenz von 50GHz zu erkennen. Die Streuparameter S21 und S12 stellen die Werte der Durchleitung des elektrischen Signals bei der jeweiligen Frequenz dar. Der lineare Phasenverlauf des Streuparameters S21 weist auf eine sehr geringe Dispersion bis zu einer Frequenz von 50GHz hin.

Die anhand der Fig. 12 bis 14 gezeigten Meßwerte lassen sich auch bei Messungen an weiteren Proben verifizieren, wobei die Figuren:

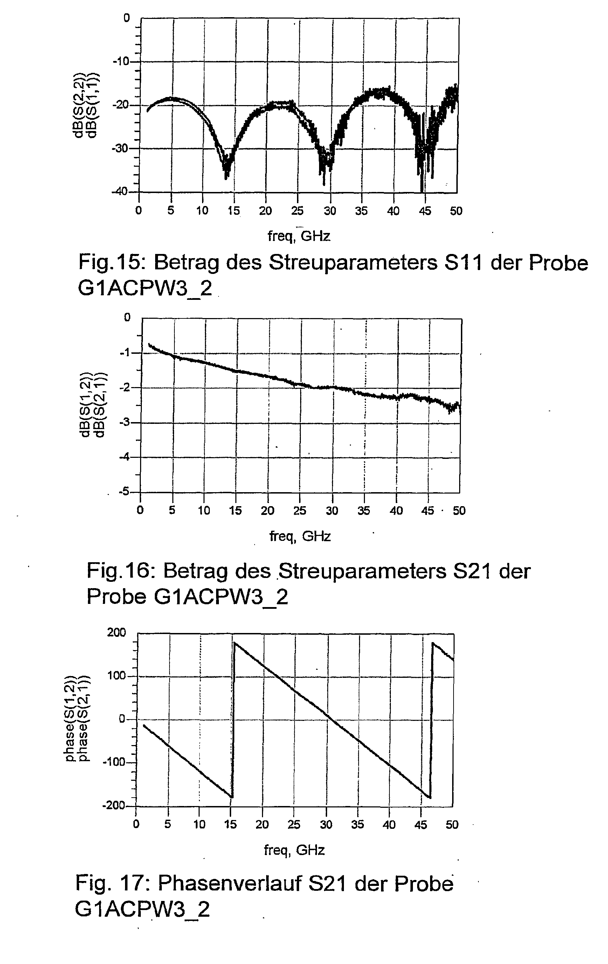

Fig. 15 bis 17: Messwerte an einer vergrabenen Coplanarleitung mit Glas 8329,

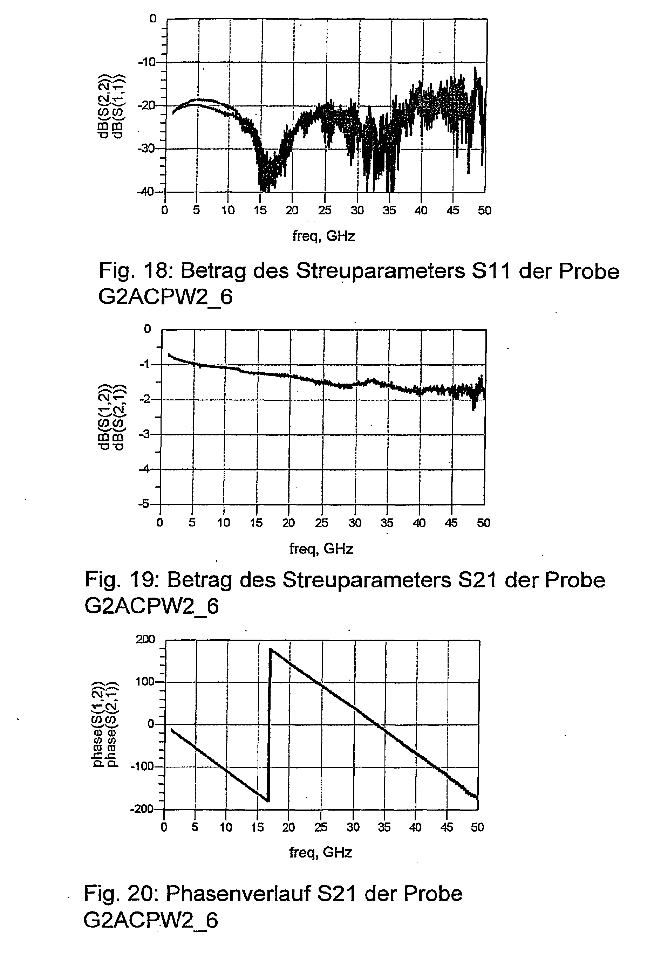

Fig. 18 bis 20: Messwerte an einer offenen Coplanarleitung mit Glas 8329, und

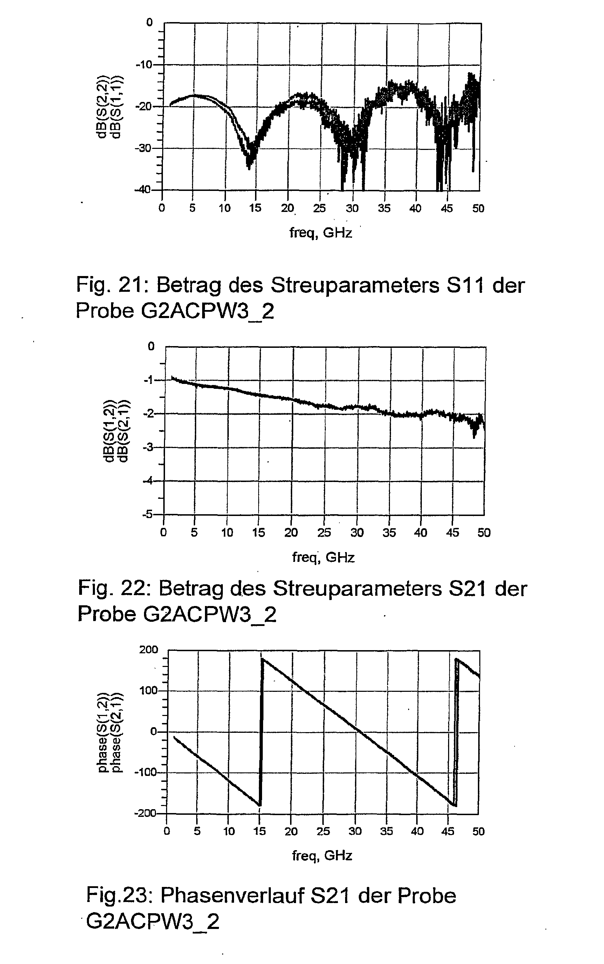

Fig. 21 bis 23: Messwerte an einer vergrabenen Coplanarleitung mit Glas G018-189 zeigen.

Bei diesen Messungen zeigt sich eine Tendenz der geringeren Dämpfung der Streuparameter S12 und S21 bei Verwendung des HF Glases G018-189.

### Bezugszeichenliste

- 1: Substrat
- 2: Halbleiterwafer
- 3: erste Seite von 1
- 4, 41, 42: Leiteranordnung
- 5: zweite Seite von 1
- 6: Schicht mit Leiterstrukturen auf 1
- 61 - 64: Leiterstrukturen von 6
- 71 - 74: Kontaktierungsbereiche
- 8: Öffungen in 9 über Kontaktierungsbereichen 71 - 74
- 9, 91-93: Aufdampfglasschicht
- 10: Bauelement
- 11: Lage mit Leiterstrukturen
- 100, 111, 112, 113: Leiterstrukturen
- 13: Abschließende. Aufdampfglasschicht
- 14: Aufdampfglas-Verkapselungsschicht
- 15: Durchkontaktierung
- 17: Lötperlen
- 19: leitendes Material
- 21: Lackstrukturen einer Zwischenschicht
- 23: passives elektrisches Bauelement
- 25: leitende Schicht
- 27: photostrukturierbare Zwischenschicht
- 29: Trennachse
- 31: Kunststoff-Abdeckung
- 33: Aktiver Halbleiter-Bereich
- 35: Anschlußstelle von 33
- 37: Durchkontakt durch 1
- 39: Passivierungsschicht
- 43: leitende Füllung von 37
- 75, 76: Kontaktierungsbereiche
- 90: Bereich der Aufdampfglasschicht auf Lackstruktur

## Patentansprüche

1. Verfahren zur Herstellung eines Bauelements (10) mit für Frequenzen höher als 1 GHz tauglicher Leiteranordnung (4, 41, 42), mit den Schritten
- Erzeugen einer strukturierten Glasschicht (9, 91, 92, 93, 13) mit zumindest einer Öffnung (8) über einem Kontaktierungsbereich (71 - 74) durch Aufdampfen eines zumindest binären Stoffsystems auf einem Substrat (1), und
- Aufbringen zumindest einer Leiterstruktur (100, 111, 112, 113) auf die Glasschicht (9, 91, 92, 93), welche einen elektrischen Kontakt mit dem Kontaktierungsbereich (71 - 74) aufweist,
wobei der Schritt des Erzeugens einer strukturierten Glasschicht (9, 91, 92, 93, 13) die Schritte
- Aufbringen einer strukturierten Zwischenschicht (21), welche den Kontaktierungsbereich abdeckt, wobei die strukturierte Zwischenschicht (21) durch photolithographisches Strukturieren eines Photolacks hergestellt wird,
- Aufdampfen einer Glasschicht (9, 91, 92, 93, 13) auf das Substrat und die darauf befindliche strukturierte Zwischenschicht (21), wobei die Dicke der Glasschicht (9, 91, 92, 93, 13) geringer ist als die der strukturierten Zwischenschicht (21), wobei das Substrat (1) während des Aufdampfens der Glasschicht (9, 91, 92, 93, 13) auf einer Temperatur zwischen 50 °C und 200 °C, bevorzugt zwischen 80 °C und 120 °C gehalten wird, und wobei das Aufdampfen der Glasschicht (9, 91, 92, 93, 13) durch Plasma-Ionen-unterstütztes Aufdampfen, englisch Plasma Ion Assisted Deposition oder PIAD, erfolgt,
- Entfernen der strukturierten Zwischenschicht (21), wobei die Bereiche (90) der Glasschicht (9, 91, 92, 93, 13), die sich auf der strukturierten Zwischenschicht (21) befinden, zum Erzeugen der Öffnung mit abgehoben werden, umfasst.

2. Verfahren gemäß Anspruch 1, **dadurch gekennzeichnet, daß** zumindest ein passives elektrisches Bauelement auf der Glasschicht (9, 91, 92, 93) aufgebracht wird, welches in Kontakt mit der zumindest einen Leiterstruktur ist.

3. Verfahren gemäß Anspruch 2, **dadurch gekennzeichnet, daß** zumindest als eines der Elemente ein Kondensator, ein Widerstand, eine Spule, ein Varistor, ein PTC, ein NTC, ein Filterelement auf der Glasschicht (9, 91, 92, 93) aufgebracht wird.

4. Verfahren gemäß einem der vorstehenden Ansprüche, **dadurch gekennzeichnet, daß** die Schritte des Erzeugens einer strukturierten Glasschicht und des Aufbringens zumindest einer Leiterstruktur (111, 112, 113) mehrfach durchgeführt werden, wobei eine nachfolgend aufgebrachte Leiterstruktur mit einem Kontaktierungsbereich einer vorhergehend aufgebrachten Leiterstruktur in Kontakt gebracht wird.

5. Verfahren gemäß einem der vorstehenden Ansprüche, **dadurch gekennzeichnet, daß** vor dem Aufdampfen der Glasschicht auf den zumindest einen Kontaktierungsbereich (71 - 74) ein leitendes, gegenüber den Kontaktierungsbereichen benachbarten Bereichen hervorragendes Material (19) aufgebracht wird, welches von der strukturierten Zwischenschicht, (21) bedeckt wird.

6. Verfahren gemäß einem der vorstehenden Ansprüche, **dadurch gekennzeichnet, daß** das Aufbringen zumindest einer Leiterstruktur die Schritte des Aufbringens einer negativ strukturierten Zwischenschicht und des Abscheidens von leitendem Material umfaßt.

7. Verfahren gemäß einem der vorstehenden Ansprüche, **dadurch gekennzeichnet, daß** das Aufbringen zumindest einer Leiterstruktur den Schritt des galvanischen Abscheidens, des Besputterns oder Aufdampfen von elektrisch leitendem Material umfaßt.

8. Verfahren gemäß einem der vorstehenden Ansprüche, **dadurch gekennzeichnet, daß** vor dem Schritt des Erzeugens einer strukturierten Glasschicht (9, 91, 92, 93, 13) zumindest eine leitende Struktur, insbesondere eine Leiterbahn auf das Substrat aufgebracht wird.

9. Verfahren gemäß einem der vorstehenden Ansprüche, **dadurch gekennzeichnet, daß** das Aufbringen zumindest einer Leiterstruktur das Aufbringen von Strukturen mit unterschiedlichen leitenden Materialien umfaßt.

10. Verfahren gemäß einem der vorstehenden Ansprüche, **gekennzeichnet durch** den Schritt des Abscheidens einer abschließenden Glasschicht (13) und das Herstellen zumindest einer Durchkontaktierung (15) in der abschließenden Glasschicht (13).

11. Verfahren nach Anspruch 10, **dadurch gekennzeichnet, daß** auf die Durchkontaktierung (15) eine Lötperle (17) aufgebracht wird.

12. Verfahren gemäß einem der vorstehenden Ansprüche, **dadurch gekennzeichnet, daß** das Substrat (1) ein Halbleitersubstrat mit aktiven Halbleiter-Bereichen (33) umfaßt, **dadurch gekennzeichnet, daß** die zumindest eine Leiterstruktur (100, 111, 112, 113) beim Aufbringen mit einer Anschlußstelle (35) des aktiven Halbleiter-Bereichs (33) in Verbindung gebracht wird.

13. Verfahren gemäß Anspruch 12, wobei der aktive Halbleiter-Bereich auf einer ersten Seite (3) des Substrats (1) angeordnet ist, **dadurch gekennzeichnet, daß** das Erzeugen einer strukturierten Glasschicht (9, 91, 92, 93, 13) mit zumindest einer Öffnung (8) über einem Kontaktierungsbereich (71 - 74) durch Aufdampfen auf das Substrat (1), und das Aufbringen zumindest einer Leiterstruktur (111, 112, 113) auf die Glasschicht (9, 91, 92, 93) auf der ersten Seite (3) des Substrats erfolgt.

14. Verfahren gemäß Anspruch 13, wobei der aktive Halbleiter-Bereich (33) auf einer ersten Seite (3) des Substrats angeordnet ist, welche einer zweiten Seite (5), auf welcher die Glasschicht (9, 91, 92, 93, 13) abgeschieden und die Leiterstruktur (100, 111, 112, 113) aufgebracht wird, gegenüberliegt, **gekennzeichnet durch** den Schritt des Einfügens zumindest eines mit einer Anschlußstelle auf der ersten Seite verbundenen Durchkontakts (37) **durch** das Substrat (1).

15. Verfahren gemäß einem der vorstehenden Ansprüche, **dadurch gekennzeichnet, daß** die zumindest eine Leiterstruktur (100, 111, 112, 113) beim Aufbringen mit einem Durchkontakt (37) durch das Substrat (1) verbunden wird.

16. Verfahren gemäß einem der vorstehenden Ansprüche, **dadurch gekennzeichnet, daß** das Substrat (1) während des Aufdampfens der Glasschicht (9, 91, 92, 93, 13) auf einer Temperatur zwischen 80 °C und 120 °C gehalten wird.

17. Verfahren gemäß einem der vorstehenden Ansprüche, **dadurch gekennzeichnet, daß** der Druck beim Aufdampfen der Glasschicht (9, 91, 92, 93, 13) höchstens im 10⁻⁴ mbar- Bereich, bevorzugt im 10⁻⁵ mbar- Bereich oder geringer gehalten wird.

18. Verfahren gemäß einem der vorstehenden Ansprüche, **dadurch gekennzeichnet, daß** die Glasschicht (9, 91, 92, 93) mit einer Abscheiderate von zumindest 0,1 µm Schichtdicke pro Minute aufgedampft wird.

19. Verfahren gemäß einem der vorstehenden Ansprüche, **dadurch gekennzeichnet, daß** das Substrat (1) im Waferverbund beschichtet wird.

## Claims

1. A method for producing a component (10) including a conductor structure (4, 41, 42) that is suitable for frequencies of more than 1 GHz, comprising the steps of:
- producing a patterned glass layer (9, 91, 92, 93, 13) having at least one opening (8) over a contact connection area (71 - 74) by vapour deposition of an at least binary material system on a substrate (1); and
- applying at least one conductor structure (100, 111, 112, 113) onto the glass layer (9, 91, 92, 93) so that the conductor structure is in electrical contact with the contact connection area (71 - 74);
wherein the step of producing a patterned glass layer (9, 91, 92, 93, 13) comprises the steps of:
- applying a patterned intermediate layer (21) that covers the contact connection area, wherein the patterned intermediate layer (21) is formed by photolithographic patterning of a photoresist;
- vapour deposition of a glass layer (9, 91, 92, 93, 13) on the substrate and on the patterned intermediate layer (21) thereon, wherein the thickness of the glass layer (9, 91, 92, 93, 13) is less than that of the patterned intermediate layer (21), wherein during the vapour deposition of the glass layer (9, 91, 92, 93, 13) the substrate (1) is held at a temperature between 50 °C and 200 °C, preferably between 80 °C and 120 °C, and wherein the vapour deposition of the glass layer (9, 91, 92, 93, 13) is accomplished by plasma ion assisted deposition, or PIAD,
- removing the patterned intermediate layer (21) so that those portions (90) of the glass layer (9, 91, 92, 93, 13) that are on the patterned intermediate layer (21) are removed therewith for producing the opening.

2. The method according to claim 1, **characterized in that** at least one passive electrical component is applied on the glass layer (9, 91, 92, 93) so that it is in contact with the at least one conductor structure.

3. The method according to claim 2, **characterized in that** the at least one of the components that is applied on the glass layer (9, 91, 92, 93) is a capacitor, a resistor, a coil, a varistor, a PTC, an NTC, a filter element.

4. The method according to any of the preceding claims, **characterized in that** the steps of producing a patterned glass layer and applying at least one conductor structure (111, 112, 113) are performed several times, wherein a subsequently applied conductor structure is electrically connected with a contact connection area of a previously applied conductor structure.

5. The method according to any of the preceding claims, **characterized in that** prior to the vapour deposition of the glass layer over the at least one contact connection area (71 - 74), a conductive material (19) is applied which projects with respect to regions adjacent to the contact connection areas and is covered by the patterned intermediate layer (21).

6. The method according to any of the preceding claims, **characterized in that** the applying of at least one conductor structure comprises the steps of applying a negatively patterned intermediate layer and of depositing conductive material.

7. The method according to any of the preceding claims, **characterized in that** the applying of at least one conductor structure comprises the step of galvanic deposition, sputter-deposition, or vapour deposition of an electrically conductive material.

8. The method according to any of the preceding claims, **characterized in that** prior to the step of producing a patterned glass layer (9, 91, 92, 93, 13) at least one conductive structure is applied onto the substrate, in particular a conductive trace.

9. The method according to any of the preceding claims, **characterized in that** the applying of at least one conductor structure comprises applying structures with different conductive materials.

10. The method according to any of the preceding claims, **characterized by** the step of depositing a final glass layer (13) and producing at least one via (15) in the final glass layer (13).

11. The method according to claim 10, **characterized in that** a solder bump (17) is applied to the via (15).

12. The method according to any of the preceding claims, **characterized in that** the substrate (1) comprises a semiconductor substrate having active semiconductor regions (33), **characterized in that** as the at least one conductor structure (100, 111, 112, 113) is applied it is electrically connected to a connection point (35) of the active semiconductor region (33).

13. The method according to claim 12, wherein the active semiconductor region is arranged on a first side (3) of the substrate (1), **characterized in that** the producing of a patterned glass layer (9, 91, 92, 93, 13) having at least an opening (8) over a contact connection area (71 - 74) by vapour deposition onto the substrate (1) and the applying of at least one conductor structure (111, 112, 113) on the glass layer (9, 91, 92, 93) is accomplished on the first side (3) of the substrate.

14. The method according to claim 13, wherein the active semiconductor region (33) is arranged on a first side (3) of the substrate, which is opposite to a second side (5) on which the glass layer (9, 91, 92, 93, 13) is deposited and the conductor structure (100, 111, 112, 113) is applied, **characterized by** the step of introducing at least one via (37) through the substrate (1) which is connected to a connection point on the first side.

15. The method according to any of the preceding claims, **characterized in that** as the at least one conductor structure (100, 111, 112, 113) is applied it is connected to a via (37) through the substrate (1).

16. The method according to any of the preceding claims, **characterized in that** during the vapour deposition of the glass layer (9, 91, 92, 93, 13) the substrate (1) is held at a temperature between 80 °C and 120 °C.

17. The method according to any of the preceding claims, **characterized in that** during the vapour deposition of the glass layer (9, 91, 92, 93, 13) the pressure is kept in the order of not more than 10⁻⁴ mbar, preferably in the order of 10⁻⁵ mbar or less.

18. The method according to any of the preceding claims, **characterized in that** the vapour deposition of the glass layer (9, 91, 92, 93) is performed at a deposition rate of at least 0.1 µm layer thickness per minute.

19. The method according to any of the preceding claims, **characterized in that** the substrate (1) is coated while it is still joined to a wafer.

## Revendications

1. Procédé de fabrication d'un composant (10) avec un montage conducteur (4, 41, 42) adapté pour des fréquences supérieures à 1 GHz, comprenant les étapes suivantes :
- production d'une couche de verre structurée (9, 91, 92, 93, 13) ayant au moins une ouverture (8) sur une zone de contact (71 - 74) par dépôt en phase vapeur d'un système de substances au moins binaire sur un substrat (1), et
- application d'au moins une structure conductrice (100, 111, 112, 113) sur la couche de verre (9, 91, 92, 93), laquelle présente un contact électrique avec la zone de contact (71 - 74),
dans lequel l'étape de production d'une couche de verre structurée (9, 91, 92, 93, 13) comprend les étapes suivantes :
- application d'une couche intercalaire structurée (21) recouvrant la zone de contact, ladite couche intercalaire structurée (21) étant produite par structuration photolithographique d'une laque photosensible,
- dépôt en phase vapeur d'une couche de verre (9, 91, 92, 93, 13) sur le substrat et sur la couche intercalaire structurée (21) disposée sur celui-ci, l'épaisseur de la couche de verre (9, 91, 92, 93, 13) étant inférieure à celle de la couche intercalaire structurée (21), le substrat (1) étant maintenu à une température entre 50°C et 200°C, préférentiellement entre 80°C et 120°C pendant le dépôt en phase vapeur de la couche de verre (9, 91, 92, 93, 13), et le dépôt en phase vapeur de la couche de verre (9, 91, 92, 93, 13) étant réalisé par dépôt en phase vapeur assisté par plasma, en anglais : Plasma Ion Assisted Deposition ou PIAD,
- retrait de la couche intercalaire structurée (21), les zones (90) de la couche de verre (9, 91, 92, 93, 13) présentes sur la couche intercalaire structurée (21) étant retirées conjointement pour réaliser l'ouverture.

2. Procédé selon la revendication 1, **caractérisé en ce qu'**au moins un composant électrique passif est appliqué sur la couche de verre (9, 91, 92, 93), lequel est en contact avec l'au moins une structure conductrice.

3. Procédé selon la revendication 2, **caractérisé en ce qu'**au moins un condensateur, une résistance, une bobine, une varistance, une thermistance PTC, une thermistance NTC, un élément de filtre est appliqué sur la couche de verre (9, 91, 92, 93) comme un des éléments.

4. Procédé selon l'une des revendications précédentes, **caractérisé en ce que** les étapes de production d'une couche de verre structurée et d'application d'au moins une structure conductrice (111, 112, 113) sont exécutées plusieurs fois, une structure conductrice appliquée consécutivement étant mise en contact avec une zone de contact d'une structure conductrice appliquée antérieurement.

5. Procédé selon l'une des revendications précédentes, **caractérisé en ce qu'**un matériau (19) conducteur, saillant par rapport aux zones de contact adjacentes, est appliqué avant le dépôt en phase vapeur de la couche de verre sur l'au moins une zone de contact (71 - 74), lequel est recouvert par la couche intercalaire structurée (21).

6. Procédé selon l'une des revendications précédentes, **caractérisé en ce que** l'application d'au moins une structure conductrice comprend les étapes d'application d'une couche intercalaire structurée négative et de dépôt de matériau conducteur.

7. Procédé selon l'une des revendications précédentes, **caractérisé en ce que** l'application d'au moins une structure conductrice comprend l'étape de dépôt galvanique, de pulvérisation cathodique ou de dépôt en phase vapeur de matériau électriquement conducteur.

8. Procédé selon l'une des revendications précédentes, **caractérisé en ce qu'**au moins une structure conductrice, en particulier une piste conductrice, est appliquée sur le substrat avant l'étape de production d'une couche de verre structurée (9, 91, 92, 93, 13).

9. Procédé selon l'une des revendications précédentes, **caractérisé en ce que** l'application d'au moins une structure conductrice comprend l'application de structures avec différents matériaux conducteurs.

10. Procédé selon l'une des revendications précédentes, **caractérisé par** l'étape de dépôt d'une couche de verre (13) terminale et la réalisation d'au moins un trou d'interconnexion (15) dans la couche de verre (13) terminale.

11. Procédé selon la revendication 10, **caractérisé en ce qu'**une perle de soudure (17) est appliquée sur le trou d'interconnexion (15).

12. Procédé selon l'une des revendications précédentes, **caractérisé en ce que** le substrat (1) comprend un substrat semi-conducteur à zones semi-conductrices actives (33), **caractérisé en ce que** l'au moins une structure conductrice (100, 111, 112, 113) est reliée à un point de connexion (35) de la zone semi-conductrice active (33) lors de l'application.

13. Procédé selon la revendication 12, dans lequel la zone semi-conductrice active est disposée sur une première face (3) du substrat (1), **caractérisé en ce que** la production d'une couche de verre structurée (9, 91, 92, 93, 13) ayant au moins une ouverture (8) sur une zone de contact (71 - 74) est réalisée par dépôt en phase vapeur sur le substrat (1), et l'application d'au moins une structure conductrice (111, 112, 113) sur la couche de verre (9, 91, 92, 93) est effectuée sur la première face (3) du substrat.

14. Procédé selon la revendication 13, dans lequel la zone semi-conductrice active (33) est disposée sur une première face (3) du substrat qui est opposée à une deuxième face (5), sur laquelle la couche de verre (9, 91, 92, 93, 13) est déposée et la structure conductrice (100, 111, 112, 113) est appliquée, **caractérisé par** l'étape d'insertion d'au moins un contact traversant (37) relié à un point de connexion sur la première face au travers du substrat (1).

15. Procédé selon l'une des revendications précédentes, **caractérisé en ce que** l'au moins une structure conductrice (100, 111, 112, 113) est reliée par un contact traversant (37) au travers du substrat (1) lors de l'application.

16. Procédé selon l'une des revendications précédentes, **caractérisé en ce que** le substrat (1) est maintenu à une température entre 80°C et 120°C pendant le dépôt en phase vapeur de la couche de verre (9, 91, 92, 93, 13).

17. Procédé selon l'une des revendications précédentes, **caractérisé en ce que** la pression est maintenue dans la plage de 10⁻⁴ mbar au maximum, préférentiellement dans la plage de 10⁻⁵ mbar ou dans une plage inférieure lors du dépôt en phase vapeur de la couche de verre (9, 91, 92, 93, 13).

18. Procédé selon l'une des revendications précédentes, **caractérisé en ce que** la couche de verre (9, 91, 92, 93) est déposée en phase vapeur avec une vitesse de dépôt d'au moins 0,1 µm d'épaisseur de couche par minute.

19. Procédé selon l'une des revendications précédentes, **caractérisé en ce que** le substrat (1) est revêtu sous forme de tranche.
